(19) **Europäisches Patentamt**

**European Patent Office**

**Office européen des brevets**

(11) **EP 0 625 811 B1**

(12) **EUROPEAN PATENT SPECIFICATION**

(45) Date of publication and mention
of the grant of the patent:
**16.02.2000 Bulletin 2000/07**

(51) Int. Cl.[7]: **H01S 3/109**

(21) Application number: **94107841.2**

(22) Date of filing: **20.05.1994**

(54) **A short wavelength light source apparatus**

Vorrichtung mit kurzwellenlängiger Lichtquelle

Appareil avec source de lumière à courte longueur d'onde

(84) Designated Contracting States:
**DE FR**

(30) Priority: **21.05.1993 JP 11974293**
**01.10.1993 JP 24652993**
**04.10.1993 JP 24788393**

(43) Date of publication of application:
**23.11.1994 Bulletin 1994/47**

(60) Divisional application:
**96110043.5 / 0 738 031**

(73) Proprietor:
**MATSUSHITA ELECTRIC INDUSTRIAL CO., LTD.**
**Kadoma-shi, Osaka 571-8501 (JP)**

(72) Inventors:
• **Kitaoka, Yasuo**
**Kawachinagano-shi, Osaka (JP)**
• **Yamamoto, Kazuhisa**
**Settsu-shi, Osaka (JP)**
• **Kato, Makoto**
**Nishinomiya-shi, Hyogo-ken (JP)**

(74) Representative:
**Schwabe - Sandmair - Marx**
**Stuntzstrasse 16**
**81677 München (DE)**

(56) References cited:
**US-A- 5 185 752**

• **APPLIED PHYSICS LETTERS., vol.61, no.23, 7 December 1992, NEW YORK US pages 2741 - 2743, XP000335052 C. ZIMMERMANN ET AL. 'Second harmonic generation at 972 nm using a distributed Bragg reflection semiconductor laser'**
• **OPTICS LETTERS., vol.18, no.1, 1 January 1993, NEW YORK US pages 34 - 36, XP000328271 R.R. STEPHENS ET AL. 'Diode-pumped upconversion laser with 100-mW output power'**
• **OPTICS LETTERS., vol.13, no.10, October 1988, NEW YORK US pages 826 - 828, XP000050989 P. ZORABEDIAN ET AL. 'Interference-filter-tuned, alignment- stabilized, semiconductor external-cavity laser'**
• **IEEE JOURNAL OF QUANTUM ELECTRONICS., vol.28, no.4, April 1992, NEW YORK US pages 1164 - 1168, XP000272719 H. NAGAI ET AL. 'Low-noise operation of a diode-pumped intracavity-doubled Nd:YAG laser using a Brewster plate'**
• **PATENT ABSTRACTS OF JAPAN vol. 17, no. 387 (P-1576) 20 July 1993 & JP-A-05 066 440 (MATSHUSHITA ELECTRIC IND.) 19 March 1993**
• **PATENT ABSTRACTS OF JAPAN vol. 16, no. 483 (P-1432) 7 October 1992 & JP-A-04 172 427 (MATSUSHITA ELECTRIC IND) 19 June 1992**
• **PATENT ABSTRACTS OF JAPAN vol. 14, no. 8 (P-987) 10 January 1990 & JP-A-01 257 922 (NEC) 16 October 1989**
• **ELECTRONICS LETTERS., vol.28, no.20, 24 September 1992, STEVENAGE GB, XP000315902 H. MASUDA ET AL. 'Pump-wavelength-locked Erbium-doped fibre amplifier employing novel external cavity for 0.98 mum laser diode.'**

## Description

## BACKGROUND OF THE INVENTION

1. Field of the Invention:

The present invention relates to a light source apparatus for use in a high-density optical disk system and the like, and particularly to a short wavelength light source apparatus incorporating a semiconductor laser as a pump light source.

2. Description of the Related Art:

In the field of high density recording using optical disks and image processing, there has been a need for light source apparatuses which incorporate semiconductor lasers as pump light sources and which provide green light or blue light by converting light emitted from the semiconductor lasers into light having different wavelengths. Such a light source apparatus is required to satisfy the following stipulations.

1) The output light has a Gaussian light intensity distribution in the lateral direction, and light can be focused at the diffraction limit.
2) The optical power of the output light is on the order of a few mW (milliwatts), and the operation is stable both in terms of the generated frequency and as a function of time.

In order to obtain a short wavelength light source apparatus having an output power of a few mW or more with a semiconductor laser incorporated as a pump light source, a method for directly converting the wavelength of semiconductor laser light is regarded as promising. The method typically uses, as an optical wavelength converting element, a polarization inversion type optical waveguide element of a quasi-phase matching (hereinafter referred to as "QPM") type using $LiTaO_3$, $LiNbO_3$, and $KTiOPO_4$ as a substrate (Yamamoto et al.; Optics Letters Vol.16, No.15, 1156 (1991)), a polarization inversion type bulk element, and/or a phase matching type non-linear optical crystal having a large non-linear optical constant, e.g. $KNbO_3$(KN).

Also regarded as promising are intracavity type short wavelength light source apparatuses incorporating cavities internalizing laser media. In such a light source apparatus, a laser medium receives laser light generated by a semiconductor laser (pump light source) so as to effect laser oscillation, and generates laser light having a longer wavelength than that of the laser light from the semiconductor laser. The generated laser light is converted into short-wavelength light (harmonics) by an optical wavelength converting element inserted in the interior of a resonator.

First, a direct wavelength conversion method using a polarization inversion type waveguide element will be described. Currently, in devices incorporating polarization inversion type waveguide element of the QPM type, blue light having an optical output power of 1.1 mW is obtained under the condition that light emitted from a semiconductor laser and entering the polarization inversion type waveguide has an intensity of 35 mW. However, while the QPM polarization inversion type waveguide element having an allowable range of wavelength variation of only 0.2 nm, the light oscillated by the semiconductor laser has a fluctuation as large as 0.2 nm/°C against temperature changes. Moreover, since there is a mode hopping of about 1 nm due to light returning to the semiconductor laser, the output of the QPM polarization inversion type waveguide element can be stable for a time period of only several seconds. Phase matching type non-linear optical crystals and QPM polarization inversion type bulk elements similarly have a relatively narrow range of allowable wavelength variation with respect to phase matching. This increases the importance of stabilization of the oscillation wavelength of a semiconductor laser used as a pump light source.

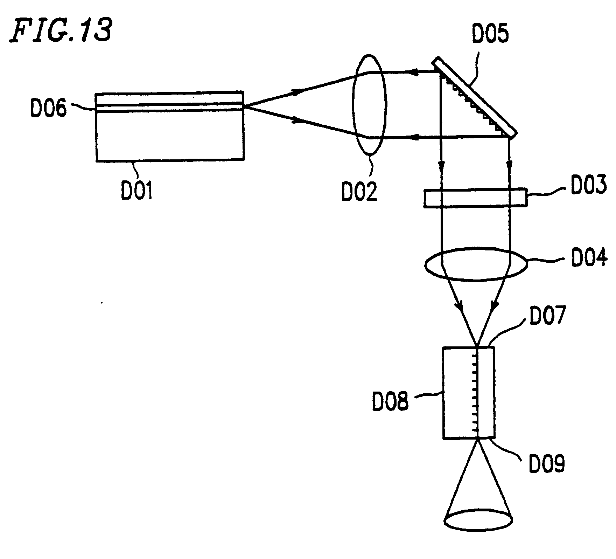

With a view to stabilizing the oscillation wavelength of a light generating apparatus incorporating a semiconductor laser as a pump light source, there has been proposed a short wavelength light source apparatus in which a grating is provided by the end of a semiconductor laser through which laser light goes out. The general configuration of this conventional short wavelength light source apparatus will be described with reference to Figure **13**.

In Figure **13**, reference numeral **D01** denotes a 50 mW-class AlGaAs semiconductor laser for the 0.83 μm band; **D02** denotes a collimating lens; **D03** denotes a λ/2 plate; **D04** denotes a focusing lens having a numerical aperture (hereinafter referred to as "N.A.") of 0.6; and **D05** denotes a grating disposed at an angle of θ with the optical axis of the semiconductor laser **D01**. The grating **D05** has a linear shape. A high reflectance coating is formed on an end face **D06** of the semiconductor laser **D01**. The grating **D05** has a wavelength dispersing effect, and therefore is capable of locking the oscillation wavelength of the semiconductor laser **D01** by feeding back light of a certain wavelength to the semiconductor laser **D01** as a first-order diffracted light. Laser light (wavelength: 830 nm) reflected from the grating **D05** is incident to the λ/2 plate **D03**, which rotates the polarizing direction of the laser light, and is lead through a focusing lens **D04** so as to be focused on an end face **D07** of the polarization inversion type waveguide element **D08**. Light propagated through the polarization inversion type waveguide element **D08** having polarization-inverted layers (period: 3.7 μm) is converted into light with a wavelength of 415 nm so as to go out through an end face **D09**. An antireflection (AR) coating which does not reflect the fundamental wave is provided on each of the end faces **D07** and **D09**. The polarization inversion type waveguide element **D08** is formed on an LiTaO$_3$ substrate.

Next, a solid laser incorporating a semiconductor laser as a pump light source will be described.

With the use of an intracavity type solid laser, green light having an optical output power of about 3 mW has been conventionally obtained by wavelength conversion with KTP (KTiOPO$_4$) when the semiconductor laser has a pumping intensity of 50 mW for Nd:YVO$_4$. However, the half-width of the absorption spectrum of a laser material of Nd:YVO$_4$ is a few nm (nanometers). Therefore, presence of a mode hopping and multiplication of the longitudinal mode may cause output noises. This makes it mandatory to stabilize the oscillation wavelength of the semiconductor laser.

In the field of light generating apparatuses incorporating semiconductor lasers capable of oscillation in a single longitudinal mode as pump light sources, there has been proposed a short wavelength light source apparatus in which a grating is provided by the end of a semiconductor laser through which laser light goes out. The general configuration of this conventional short wavelength light source apparatus will be described with reference to Figure **25**.

In Figure **25**, reference numeral **Q01** denotes a 60 mW-class AlGaAs semiconductor laser for the 809 nm band; **Q02** denotes a collimating lens; **Q03** denotes a focusing lens (f:14.5 mm); **Q04** denotes a grating disposed at an angle of θ with the optical axis of the semiconductor laser **Q01**. The grating **Q04** has a linear shape. A diffraction efficiency of about 10% was obtained under the following conditions: the incident angle was 30°; the depth was 0.29 μm; and the pitch was 0.83 μm. The grating **Q04** has a wavelength dispersing effect, and therefore is capable of locking the oscillation wavelength of the semiconductor laser **Q01** by feeding back light of a certain wavelength to the semiconductor laser **Q01** as a first-order diffracted light. Laser light (zero-order diffracted light) reflected from the grating **Q04** is lead through the focusing lens **Q03** so as to be focused on an end face **Q08** of a laser medium of Nd:YVO$_4$ **Q07**. The fundamental wave, resonated between an output mirror **Q09** and the end face **Q08** of the Nd:YVO$_4$ laser medium **Q07** is subjected to wavelength conversion by a non-linear device optical crystal of KTP(KTiOPO$_4$) **Q10** so as to be output through the output mirror **Q09**.

As is seen from Figures **13** and **25**, when attempting to stabilize the longitudinal mode oscillation of a semiconductor laser with the use of a grating, the stability may be drastically lowered due to temporal change of the grating and/or the posture in which it is maintained and change in the surrounding temperature. The grating angle dependence of the wavelength stability is 28 nm/deg.

Moreover, the whole module (apparatus) cannot be configured in a linear shape because the optical axis of the semiconductor laser is bent with respect to the optical axis of the emitted light. Therefore, miniaturization of such a short wavelength light source apparatus becomes difficult.

Furthermore, use of a grating for adjustments against changes in the refractive index due to temperature changes of the optical wavelength converting element and/or optical damage, that is, changes in the phase matching wavelength, requires a complicated and high-precision adjustment mechanism.

US-A-5185752 defines a short wavelength light source apparatus according to the preamble of claims 1, 9, 27 and 45.

## SUMMARY OF THE INVENTION

A short wavelength light source apparatus according to the present invention is defined by the features of independent claims 1, 9, 27 and 45. Preferred embodiments are defined by the subclaims.

## BRIEF DESCRIPTION OF THE DRAWINGS

Figure **1** is a view showing a short wavelength light source apparatus according to the present invention incorporating a semiconductor laser as a pump light source, a polarization inversion type waveguide element, and a thin film optical element (reflective type filter) stabilizing the oscillation wavelength of the semiconductor laser.

Figure **2** is a graph showing a reflection spectrum of a thin film optical element (reflective type filter) according to the present invention.

Figure **3** is a view showing a short wavelength light source apparatus according to the present invention incorporating a semiconductor laser as a pump light source, a polarization inversion type waveguide element, and a thin film optical element (transmission type filter) stabilizing the oscillation wavelength of the semiconductor laser.

Figure **4** is a graph showing a reflection spectrum of a thin film optical element (transmission type filter) according to the present invention.

Figure **5** is a view showing a short wavelength light source apparatus according to the present invention incorporating a semiconductor laser as a pump light source, a polarization inversion type waveguide element, and a thin film optical element (transmission type filter) stabilizing the oscillation wavelength of the semiconductor laser.

Figure **6** is a view showing a short wavelength light source apparatus according to the present invention incorporating a semiconductor laser as a pump light source, a polarization inversion type waveguide element, and a thin film optical element (transmission type filter) stabilizing the oscillation wavelength of the semiconductor laser.

Figure **7** is a view showing a short wavelength light source apparatus according to the present invention incorporating a semiconductor laser as a pump light source, a polarization inversion type bulk element, and a thin film optical element (transmission type filter) stabilizing the oscillation wavelength of the semiconductor laser.

Figure **8** is a view showing a short wavelength light source apparatus according to the present invention incorporating a semiconductor laser as a pump light source, a polarization inversion type bulk element, and a thin film optical element (transmission type filter) stabilizing the oscillation wavelength of the semiconductor laser.

Figure **9A** is a view showing a short wavelength light source apparatus according to the present invention in which a dielectric multilayer film is provided on an outgoing end face of a semiconductor laser.

Figure **9B** is a view showing a short wavelength light source apparatus according to the present invention in which a dielectric multilayer film is provided on an end face of a polarization inversion type waveguide element.

Figure **10** is a view showing a short wavelength light source apparatus according to the present invention in which a dielectric multilayer film is provided on an end face of a polarization inversion type waveguide element.

Figure **11A** is a schematic view showing a short wavelength light source apparatus according to the present invention including polarization-inverted layers having a constant polarization inversion period.

Figure **11B** is a schematic view showing a short wavelength light source apparatus according to the present invention including polarization-inverted layers having a polarization inversion period of a split structure.

Figure **11C** is a schematic view showing a short wavelength light source apparatus according to the present invention including polarization-inverted layers having a polarization inversion period of a chirp structure.

Figure **12** is a view showing a short wavelength light source apparatus according to the present invention incorporating a semiconductor laser as a pump light source for exciting a polarization inversion type waveguide element having a polarization inversion period of a split structure, and a thin film optical element stabilizing the oscillation wavelength of the semiconductor laser.

Figure **13** is a view showing a conventional short wavelength light source apparatus incorporating a semiconductor laser and a polarization inversion type waveguide element, in which grating feedback technique is used.

Figure **14** is a graph showing the respective output power stabilities of a short wavelength light source apparatus according to the present invention incorporating a transmission type filter, and a conventional short wavelength light source apparatus in which grating feedback technique is used.

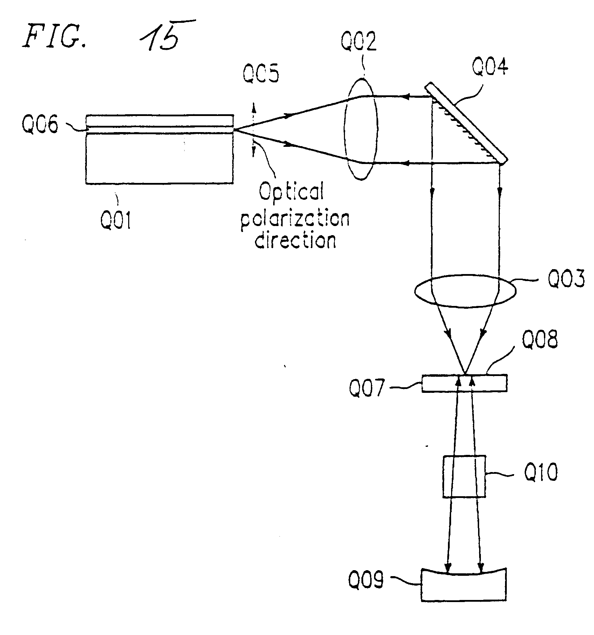

Figure **15** is a view showing a conventional short wavelength light source apparatus incorporating a semiconductor laser and an intracavity type solid laser, in which grating feedback technique is used.

## DESCRIPTION OF THE PREFERRED EMBODIMENTS

Hereinafter, the present invention will be described by way of examples, with reference to the accompanying drawings.

Example 1

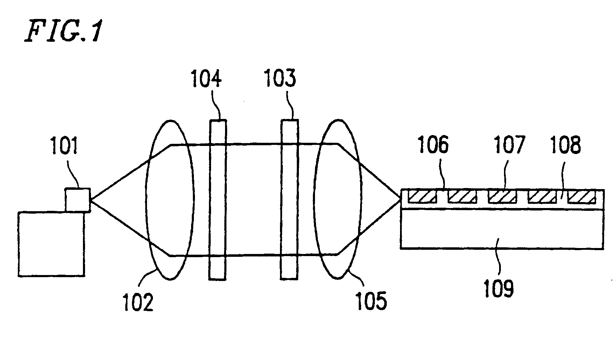

Figure **1** schematically shows a configuration for a short wavelength light source apparatus according to a first example of the present invention. The short wavelength light source apparatus includes a semiconductor laser **101** including an active layer (not shown) for emitting laser light, an optical wavelength converting element **106** for receiving at least a portion of the generated laser light so as to generate short wavelength light (harmonics) having a shorter wavelength than that of the laser light. The semiconductor laser **101** is a 150 mW-class single longitudinal mode laser with an oscillation wavelength of the 870 nm band. The optical wavelength converting element **106** is a polarization inversion type waveguide element.

This short wavelength light source apparatus includes a thin film optical element **103** in addition to an ordinary optical system including lenses, etc. The thin film optical element **103** selectively reflects a portion of laser light generated by the semiconductor laser **101** that belongs to a predetermined wavelength band so as to feed back the reflected light to the active layer of the semiconductor laser **101**. The thin film optical element

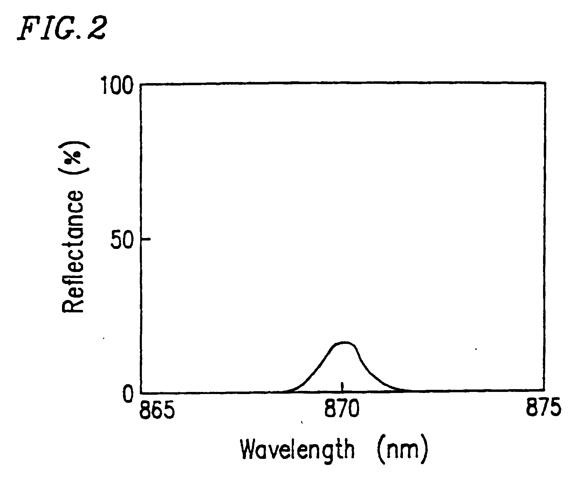

103 may be, for example, a band-stop type (reflective type) filter formed of a dielectric multilayer film, and can be obtained by forming a layer of dielectric material such as $SiO_2$ and $TiO_2$ on a glass substrate having a thickness of 0.5 mm. Figure **2** shows reflection characteristics of the thin film optical element **103**. As is seen from Figure **2**, the reflectance of the thin film optical element **103** has a peak of about 10%. Light in the vicinity of the 870 nm band is optically fed back to the active layer of the semiconductor laser **101** by the thin film optical element **103**. The thin film optical element **103** feeds back a relatively wide spectrum width of about 5 nm of reflected light to the active layer of the semiconductor laser **101**.

According to the short wavelength light source apparatus of the present example, as is shown in Figure **1**, light generated by the semiconductor laser **101** is collimated by a lens **102** (N.A.: 0.55), and then is incident to the thin film optical element **103**. The thin film optical element **103** is disposed perpendicularly to the optical axis of the semiconductor laser **101**. A portion (about 10% or less) of light incident to the thin film optical element **103** that is in the vicinity of the 870 nm band is optically fed back to the active layer of the semiconductor laser **101**. The rest of the laser light, i.e. a portion of the laser light which is not reflected by the thin film optical element **103**, is transmitted through the thin film optical element **103**.

As is shown in Figure **2**, the thin film optical element **103** feeds back a relatively wide spectrum width of about 5 nm of reflected light to the active layer of the semiconductor laser **101**. However, since the gain of a semiconductor laser depends largely on the wavelength, the semiconductor laser **101** of the present example achieved a stable oscillation in a single longitudinal mode by feeding back the reflected light having the above-mentioned spectrum, and the oscillation wavelength was stabilized at 870 nm.

In the present example, the polarization direction of the laser light transmitted through the thin film optical element **103** is rotated by 90° around the optical axis by means of a λ/2 plate **104**. The laser light, after being transmitted through the λ/2 plate **104**, is focused on an incident end face of the polarization inversion type waveguide element (optical wavelength converting element) **106** by a focusing lens **105**. Thereafter, the laser light having a wavelength of 870 nm is converted into blue light having a wavelength of 435 nm while being propagated through a waveguide **108**. As a result, blue light is stably emitted from an end face of the polarization inversion type waveguide element **106** (hereinafter, this end face of a given waveguide will be referred to as an 'outgoing end face').

Hereinafter, the polarization inversion type waveguide element **106** will be described. The polarization inversion type waveguide element **106** of the present example includes a $LiTaO_3$ substrate **109**, an optical waveguide **108** (width: 4 μm) formed on the

$LiTaO_3$ substrate **109**, and polarization-inverted layers **107** (period: 4 μm). The polarization inversion type waveguide element **106** is formed in the following manner.

First, a Ta film is deposited on the $LiTaO_3$, and thereafter is patterned into a periodic pattern by using a usual photoprocess and a dry etching method, whereby a plurality of slits are formed in the Ta film. Next, the $LiTaO_3$ substrate is subjected to a proton exchanging process for 30 minutes at 260°C, so as to form a proton exchanged layer (thickness: 0.8 μm) under the slits in the Ta layer. Thereafter, the $LiTaO_3$ substrate **109** is subjected to a heat treatment for 10 minutes at 590°C. The temperature during the heat treatment is increased at a rate (elevation rate) of 10°C/min., and is decreased at a rate (cooling rate) of 50°C/min. The Li concentration in regions directly below the proton exchanged layer of the $LiTaO_3$ **109** decreases, so that the Curie temperature in such regions decreases. As a result, the regions under the proton exchanged layer have the capability of locally conducting polarization inversion. Thus, the polarization-inverted layers **107** are formed in the $LiTaO_3$ substrate **109**.

Next, the $LiTaO_3$ substrate is subjected to an etching process for 2 minutes with the use of a solution of HF and $HNF_3$ mixed at a ratio of 1:1 so as to remove the Ta film. Then, the optical waveguide **108** is formed in the polarization-inverted layers **107** by a proton exchange process. Ta is patterned to a stripe shape so as to form a Ta mask for forming the optical waveguide **108**. The Ta mask thus obtained has slits each having a width of 4 μm and a length of 12 mm. The $LiTaO_3$ substrate **109**, which is covered with the above-mentioned Ta mask, is subjected to a proton exchange process for 16 minutes at 260°C so as to form high refractive index layer having a thickness of 0.5 μm, and is subjected to a heat treatment for 10 minutes at 380 °C after removing the Ta mask. The regions directly below the slits of the Ta mask, where proton exchange has been conducted, form the optical waveguide layer **108** of which refractive index has been increased by about 0.03.

Since the refractive index of the $LiTaO_3$ substrate **109** is about 2.2, Fresnel reflection of about 14% is inevitably generated unless a coating is provided on end faces thereof. If Fresnel reflection is present, there emerges light returning to the semiconductor laser **101**, thereby hindering stabilization of the oscillation wavelength by the thin film optical element **103**. Therefore, it is preferable to form an AR coating which does not reflect light having a wavelength of 870 nm on the incident end face and the outgoing end face of the polarization inversion type waveguide element **106**.

The λ/2 plate **104** inserted in the optical system composed essentially of the collimating lens **102** and the focusing lens **105** may alternatively be formed on the thin film optical element **103**. In that case, the number of the component elements of the short wavelength light source apparatus would be reduced, thereby facilitating further miniaturization of the short wavelength light source apparatus.

## Example 2

Although the polarization inversion type waveguide element **106** including a substrate composed of LiTaO₃(LT) is used as an optical wavelength converting element in the short wavelength light source apparatus shown in Figure **1**, similarly stable short wavelength light can be obtained by using: a polarization inversion type waveguide element including a substrate composed of $LiNbO_3$(LN) or $KTiOPO_4$(KTP); a non-linear optical crystal having a large non-linear optical constant, e.g. $KNbO_3$(KN); or a polarization inversion type bulk element including a substrate composed of LT, LN, or KTP.

An AR coating which does not reflect light having a wavelength of 870 nm is provided on an incident end face and an outgoing end face of the optical wavelength converting element according to the present example.

A method for fabricating a polarization inversion type bulk element having deep polarization-inverted layers will be described.

Deep polarization-inverted layers can be fabricated by a drawing method using an electron beam (EB), a focusing ion beam (FIB) method, etc., and by a proton exchange method. A polarization inversion type bulk element can be fabricated by any of the following four methods.

### (1) A method using EB irradiation i)

A substrate composed of a dielectric material of $LiNbO_3$ or $LiTaO_3$ is irradiated with charged particles (electrons) accelerated at an acceleration voltage in the range of 10 to 100 keV in such a manner that the current density at a surface of the substrate becomes 1 to 1000 $\mu A/mm^2$ while applying an electric field of 10 V/mm to 100kV/mm. Thus, deep polarization-inverted layers can be obtained.

### (2) A method using EB irradiation ii)

A metal film is vapor deposited on a +C plane of a substrate composed of a dielectric material of $LiNbO_3$ or $LiTaO_3$ (C plates), and is grounded. An electron beam accelerated at an acceleration voltage of 25 keV is focused so as to be radiated on each substrate from a -C plane thereof so that the polarization at the irradiated portion is inverted. The polarization-inverted layers thus obtained reach the bottom face of the substrate (thickness: 0.5 mm). Thus, deep polarization-inverted layers can be obtained.

### (3) A method using FIB irradiation

By using a liquid metal source of AuSi as an ion source, $Si^{2+}$ ions are focused and radiated on a substrate, the $Si^{2+}$ ions having been separated and selected by means of an electric field filter. The focused area extends about 1 μm ø. The substrate is a C plate composed of $LiTaO_3$, which is grounded to a sample holder with metal paste. The $Si^{2+}$ ions are focused on the +C plane of the substrate. A periodic scanning is conducted with the focused ions while utilizing computer control.

The above-mentioned irradiation is conducted under the conditions that: the acceleration energy is 200 keV; the amount of current is 120 pA; and the scanning velocity is 84 μm/sec. The polarization-inverted layers thus obtained reach the bottom face of the substrate, and has a width of 1.8 μm. The width of each polarization-inverted layer is uniform along the depth direction of the polarization-inverted layer. On forming periodic polarization-inverted layers (period:4 μm) under the same conditions as above, a uniform periodic structure having a period of 4 μm was formed, with the width and the depth of each polarization-inverted layer being 1.8 μm and 0.5 mm, respectively.

### (4) A method using proton exchange technique

Ta is vapor deposited on a -C plane of a $LiTaO_3$ substrate and is subjected to a photolithography and a dry etching so as to form stripes having a period of 4 μm. Several drops of pyrophoric acid are placed on the stripes, and a heat treatment is conducted for 30 minutes on a hot plate heated at 230°C. Thus, deep polarization-inverted layers can be obtained.

By any of the above mentioned methods (1) to (4), deep polarization-inverted layers are formed on an $LiTaO_3$ substrate. An incident end face and an outgoing end face are optically polished, and are each coated with an AR coating which does not reflect light having a wavelength of 870 nm, whereby a polarization inversion type bulk element according to a second example of the present invention is formed. Thus, a short wavelength light source apparatus is realized with the polarization inversion type bulk element being incorporated instead of the polarization inversion type waveguide element **106** shown in Figure **1**.

## Example 3

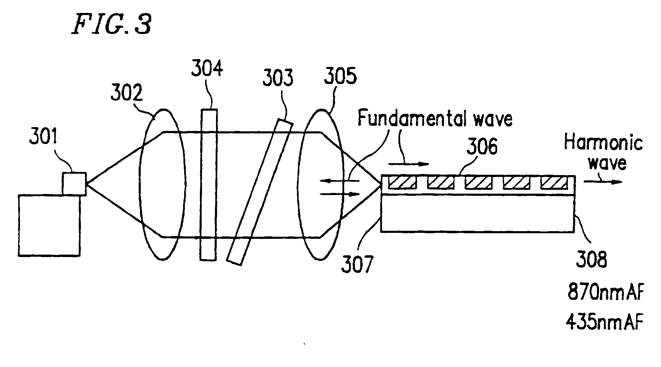

Hereinafter, a short wavelength light source apparatus according to a third example of the present invention will be described with reference to Figure **3**.

The short wavelength light source apparatus shown in Figure **3** includes a semiconductor laser **301** including an active layer (not shown) for emitting laser light, an optical wavelength converting element **306** for receiving at least a portion of the generated laser light so as to generate short wavelength light (harmonics) having a shorter wavelength than that of the laser light. The semiconductor laser **301** is a 150 mW-class single longitudinal mode laser with an oscillation wavelength of the 870 nm band. The optical wavelength converting element **306** is a polarization inversion type waveguide element.

This short wavelength light source apparatus includes a thin film optical element **303** in addition to an ordinary optical system including lenses, etc. The thin film optical element **303** selectively transmits a portion of laser light generated by the semiconductor laser **301** that belongs to a predetermined wavelength band. A portion of the transmitted light is fed back to the active layer of the semiconductor laser **301**, as is described later in the present specification. The thin film optical element **303** may be, for example, a band-pass type (transmission type) filter formed of a dielectric multilayer film, and can be obtained by forming a few dozens of layers of dielectric material such as $TiO_2$ on a glass substrate having a thickness of 0.5 mm.

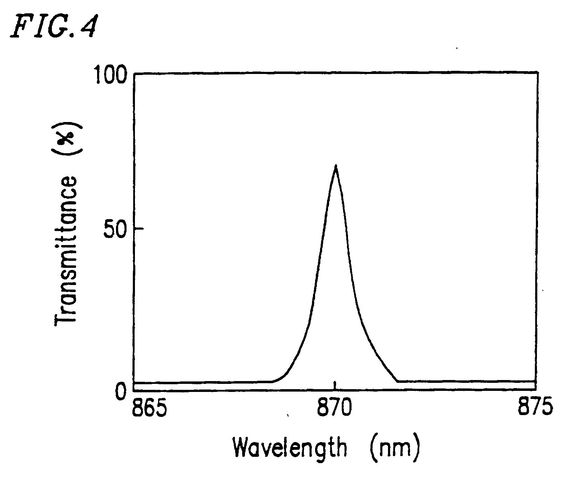

Figure **4** shows transmission characteristics of the thin film optical element **303**. As is seen from Figure **4**, the reflectance of the thin film element **303** has a maximum transmittance of about 80% at a wavelength of 870 nm. The half-width of the transmission spectrum of the thin film element **303** is 1 nm. The transmittance of the thin film optical element **303** has angle dependence. The transmission spectrum shown in Figure **4** represents a spectrum in the case where the principal plane of the thin film optical element **303** is disposed at an angle (i.e. incident angle) of 20° with the optical axis. When the incident angle is 20°, the shift amount of the transmission center wavelength of the thin film optical element **303** has an angle dependence of 1.5 nm/deg; when the incident angle is in the vicinity of 10°, the shift amount of the transmission center wavelength has an angle dependence of 0.9 nm/deg; and when the incident angle is 0°, the shift amount of the transmission center wavelength has substantially no angle dependence.

According to the short wavelength light source apparatus of the present example, as is shown in Figure **3**, light generated by the semiconductor laser **301** is collimated by a lens **302**, and then is incident to the thin film optical element **303**. The thin film optical element **303** is disposed obliquely with respect to the optical axis of the semiconductor laser **301**. According to the present example, only light having a wavelength in the vicinity of 870 nm is selectively transmitted through the thin film optical element **303** when the thin film optical element **303** is disposed at an angle of 20° with the optical axis of the semiconductor laser **301**. The rest of the laser light, i.e. a portion of the laser light which is not transmitted through the thin film optical element **303**, is reflected by the thin film optical element **303**. The reflected light is not fed back to the active layer of the semiconductor laser **301**, since the thin film optical element **303** is disposed obliquely with respect to the optical axis of the semiconductor laser **301**.

In the present example, the polarization direction of the laser light transmitted through the thin film optical element **303** is rotated by 90° around the optical axis by means of a λ/2 plate **304**. The laser light, after being transmitted through the λ/2 plate **304**, is focused on an incident end face **307** of the polarization inversion type waveguide element (optical wavelength converting element) **306** by a focusing lens **305**.

An AR coating is provided on the incident end face **307** of the polarization inversion type waveguide element **306**; otherwise, Fresnel reflection of about 14% would inevitably be generated.

Since light generated by the semiconductor laser **301** is focused on the incident end face **307** of the polarization inversion type waveguide element **306**, an outgoing end face of the semiconductor laser **301** and the incident end face **307** of the polarization inversion type waveguide element **306** are confocally disposed. As a result, a portion of light generated by the semiconductor laser **301** is reflected by the incident end face **307** of the polarization inversion type waveguide element **306** so as to be fed back to the active layer of the semiconductor laser **301**.

As is described above, by disposing the thin film optical element **303** between the semiconductor laser **301** and the polarization inversion type waveguide element **306** at an angle of 20° with the optical axis, only light having a wavelength in the vicinity of 870 nm is incident to and reflected by the incident end face **307**, so as to be optically fed back to the semiconductor laser **301**. As a result, the semiconductor laser **301** achieves stable oscillation in a single longitudinal mode, with the oscillation wavelength being stabilized at 870 nm.

The light (wavelength: 870 nm) emitted from the incident end face **307** of the polarization inversion type waveguide element **306** and coupled to a waveguide of the polarization inversion type waveguide element **306** is converted into blue light having a wavelength of 435 nm while being propagated through the waveguide. As a result, blue light is stably emitted from an outgoing end face **308** of the polarization inversion type waveguide element **306**.

A portion of the light coupled to the above-mentioned waveguide is Fresnel reflected by the outgoing end face **308**. Since it is preferable to restrain light having a wavelength of 870 nm from being reflected by the outgoing end face **308**, an AR coating which does not reflect the fundamental wave (wavelength: 870 nm) is provided on the outgoing end face **308**.

The polarization inversion type waveguide element **306** includes polarization-inverted layers having a period of 4 μm and an optical waveguide having a width of 4 μm and formed in an $LiTaO_3$ substrate, as in the case of the polarization inversion type waveguide element **106** in Example 1. By adjusting the temperature of the polarization inversion type waveguide element **306** so that the phase matching wavelength is tuned to be 870 nm, the fundamental wave (870 nm) is converted into light having a wavelength of 435 nm. As a result, blue light is obtained through the outgoing end face **308** of the polarization inversion type waveguide element **306**.

The polarization inversion type waveguide element **306** has a length of 10 mm and a conversion efficiency of 200%/W. As a result, a harmonic wave of about 10 mW is obtained, the fundamental wave power of about 70 mW being coupled to the waveguide. It is preferable to provide an AR coating which does not reflect the 430 nm harmonic wave on the outgoing end face **308** so that the harmonic light can be obtained at even higher efficiency.

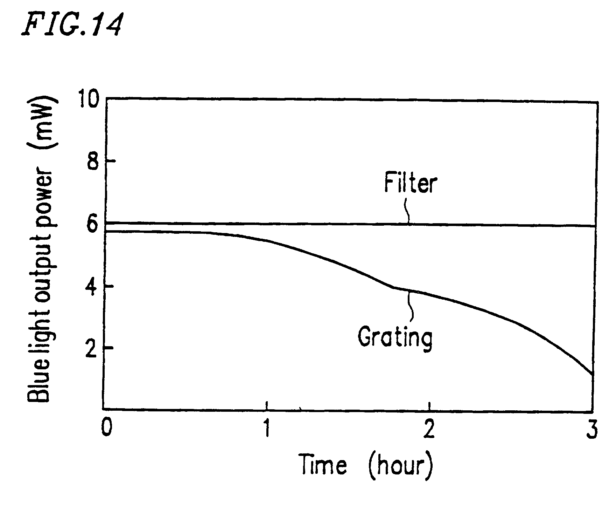

Figure **14** shows temporal change in the output power of the short wavelength light source apparatus of the present example in comparison with a case where a grating is employed. It will be seen from Figure **14** that the polarization inversion type waveguide element **306** is stable as a function of time as well, since the wavelength shifts by a smaller amount depending on the angle when using a filter than when using a grating. By wavelength locking using such a thin film optical element **303**, the wavelength does not shift depending on the angle by such a large amount as 28 nm/deg as in the case where a grating is used. Therefore, the adjustment using the thin film optical element **303** is facilitated, and the short wavelength light source apparatus is made stable against temporal deterioration even if configured as a module. Moreover, the short wavelength light source apparatus of the present example is stable against temperature changes as well (wavelength shift against temperature changes: 0.005 nm/°C). The short wavelength light source apparatus is also stable against changes in moisture.

Usually, an AR coating which does not reflect laser light generated from a semiconductor laser is provided on an end face of a polarization inversion type waveguide element. However, it is difficult to maintain the reflectance of the end face below about 0.1%. Even if the reflectance of the end face is reduced to about 0.1%, the longitudinal mode of the semiconductor laser may become unstable due to a small amount of light reflected by the end face, which amount of light is fed back to the semiconductor laser. The present example effectively utilizes the returned light due to the reflection so as to stabilize the oscillation of the semiconductor laser. Therefore, the present example has considerable practical significance.

Although Fresnel reflection at the incident end face of the polarization inversion type waveguide element is utilized in the present example, it is also applicable to optimize the reflection amount by providing an appropriate reflection coating on the incident end face so as to adjust the reflection amount at the incident end face. The higher the reflectance of such a reflection coating is, the more stable the oscillation wavelength of the semiconductor laser becomes. However, the higher the reflectance of the reflection coating is, the smaller amount of light is coupled to the waveguide, resulting in a lower output power of the harmonic light. If a reflection coating having a reflectance of about 5%, on the other hand, the output power of the harmonic light increases due to an increase in the amount of light coupled to the waveguide.

The λ/2 plate **304** disposed in the optical system (including the collimating lens **302** and the focusing lens **305**) may alternatively be formed on the thin film optical element **303**. In that case, the number of the component elements of the short wavelength light source apparatus would be reduced, thereby facilitating further miniaturization of the short wavelength light source apparatus.

Moreover, the peak wavelength of the transmission spectrum of the thin film optical element **303** has angle dependence. By mounting a rotation mechanism on the thin film optical element **303** and adjusting the angle of the thin film optical element **303** with respect to the laser light by means of the rotation mechanism, it becomes possible to control the peak wavelength of the transmission spectrum at a high accuracy. By using such a rotation mechanism, it becomes possible to monitor the output power of harmonic wave obtained from the outgoing end face **308** of the polarization inversion type waveguide element **306**. Specifically, the angle which the thin film optical element **303** constitutes with the laser light is adjusted by monitoring the output power of harmonic wave obtained from the outgoing end face **308** of the polarization inversion type waveguide element **306** so that the monitored output power is maximized. By making such an adjustment, the oscillation wavelength of the semiconductor laser **301** can be made equal to the phase matching wavelength of the polarization inversion type waveguide element **306**.

By further providing a feedback circuit for controlling the rotation mechanism in addition to a mechanism for monitoring the output power of the harmonic wave, stable harmonic wave output can be obtained. By providing such a rotation mechanism for the thin film optical element **303**, the oscillation wavelength of the semiconductor laser **301** can be stabilized against changes in the refractive index of the substrate of the polarization inversion type waveguide element **306** due to changes in the temperature of the thin film optical element **303** and/or optical damage (photorefractive effect), so that stable output power of the harmonic wave can be obtained. As the rotation mechanism, a rotation monitor and/or an actuator may be used. It is also applicable to use a piezo element on a fulcrum so that the piezo element has a rotatory action.

Moreover, only one thin film optical element **303** is disposed between the semiconductor laser **301** and the polarization inversion type waveguide element **306** in the present example, a plurality of thin film optical elements may alternatively be inserted therein, so that the half width of the transmission spectrum shown in Figure **4** becomes substantially narrow, thereby improving the wavelength selectivity.

Example 4

Although the polarization inversion type waveguide element **306** including a substrate composed of LiTaO$_3$(LT) is used as an optical wavelength converting element in the short wavelength light source apparatus shown in Figure **3**, similarly stable short wavelength light can be obtained by using: a polarization inversion type waveguide element including a substrate composed of LiNbO$_3$(LN) or KTiOPO$_4$(KTP); an organic or inorganic non-linear optical crystal (a ring resonator structure, phase matching type waveguide device, etc.) having a large non-linear optical constant, e.g. KNbO$_3$(KN); or a polarization inversion type bulk element including a substrate composed of LT, LN, or KTP described in Example 2. In this case, too, it is preferable to provide an AR coating which reflects neither light having a wavelength of 870 nm nor light having a wavelength of 435 nm on an incident end face and an outgoing end face of the optical wavelength converting element.

Example 5

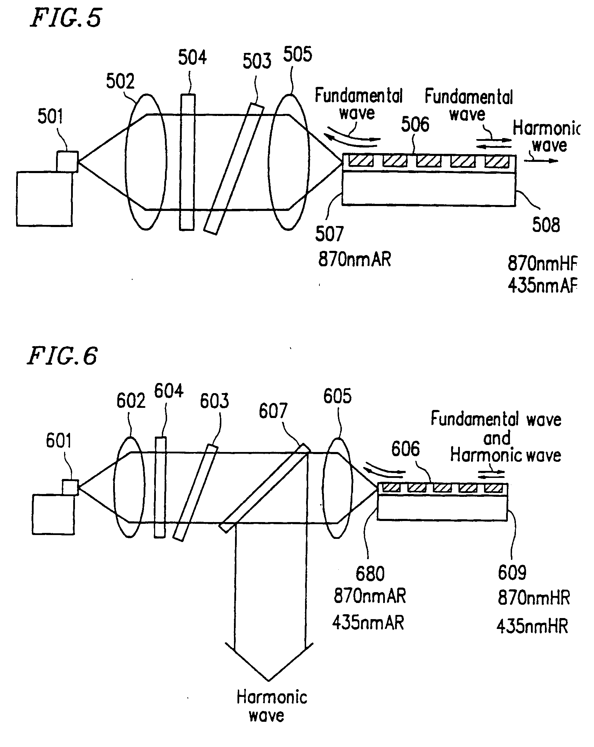

Hereinafter, a short wavelength light source apparatus according to a fifth example of the present invention will be described with reference to Figure **5**.

The short wavelength light source apparatus shown in Figure **5** includes a semiconductor laser **501** including an active layer (not shown) for emitting laser light, an optical wavelength converting element **506** for receiving at least a portion of the generated laser light so as to generate short wavelength light (harmonics) having a shorter wavelength than that of the laser light. The semiconductor laser **501** is a 150 mW-class single longitudinal mode laser with an oscillation wavelength of the 870 nm band. The optical wavelength converting element **506** is a polarization inversion type waveguide element.

This short wavelength light source apparatus includes a thin film optical element **503** having the same structure as that of the thin film optical element **303** in Example 3. Accordingly, the thin film optical element **503** has the transmission characteristics shown in Figure **4**. The present example is characterized in that Fresnel reflection occurring at an outgoing end face **508** of the polarization inversion type waveguide element **506** is utilized as returned light to the semiconductor laser **501**. An incident end face of the polarization inversion type waveguide element **506** has a low reflectance. It is preferable to provide an AR coating on the incident end face **507**.

Light emitted from the semiconductor laser **501** is focused on the incident end face of the polarization inversion type waveguide element **506** so as to be coupled to an optical waveguide of the polarization inversion type waveguide element **506**. An outgoing end face of the semiconductor laser **501** and the incident end face **507** of the polarization inversion type waveguide element **506** are confocally disposed. The outgoing end face of the semiconductor laser **501** also constitutes a confocal system with the outgoing end face **508** of the polarization inversion type waveguide element **506**. As a result, light reflected by the outgoing end face **508** is all optically fed back to the active layer of the semiconductor laser **501**. If the thin film optical element **503** is not provided, the above-mentioned reflected light (returned light) may cause the semiconductor laser **501** to have mode hopping or to have a multitude of modes.

By disposing the thin film optical element **503** between the semiconductor laser **501** and the polarization inversion type waveguide element **506** at an angle of 20° with the optical axis, it is ensured that only light having a wavelength in the vicinity of 870 nm is incident to the incident end face **507** and coupled to the optical waveguide, so that only light having a wavelength in the vicinity of 870 nm which is reflected by the outgoing end face **508** of the polarization inversion type waveguide element **506** is optically fed back to the semiconductor laser **501**. As a result, the longitudinal mode of the semiconductor laser **501** is stabilized as a single mode in the vicinity of 870 nm.

By providing a high reflectance (HR) coating for reflecting light having a wavelength of 870 nm (preferably at a 100% reflectance) on the outgoing end face **508**, the amount of light returning to the semiconductor laser **501** can be increased, so as to further stabilize the operation of the short wavelength light source apparatus.

As is seen from Figure **5**, the thin film optical element **503** is disposed at an angle with the optical axis of the semiconductor laser **501**. The thin film optical element **503** reflects light having wavelengths other than those in the vicinity of 870 nm. In other words, light having wavelengths other than those in the vicinity of 870 nm is not optically fed back to the active layer of the semiconductor laser **501**. By so adjusting the temperature of the polarization inversion type waveguide element **506** that the phase matching wavelength is tuned to be 870 nm, the fundamental wave (870 nm) coupled to the polarization inversion type waveguide element **506** is converted into light having a wavelength of 435 nm. As a result, blue light is obtained through the outgoing end face **508** of the polarization inversion type waveguide element **506**. The temperature-based tuning may be realized by, although not shown in Figure 5, fixing the polarization inversion type waveguide element **506** on a Peltier element, or providing a heater on the optical waveguide.

The polarization inversion type waveguide element **506** has a length of 10 mm and a conversion efficiency of 200%/W. As a result, a harmonic wave of about 10 mW is obtained, the fundamental wave power of about 70 mW being coupled to the waveguide. It is preferable to provide an AR coating which does not reflect the 435 nm harmonic wave on the outgoing end face **508** of the polarization inversion type waveguide element **506** so that the harmonic light can be obtained at even higher efficiency.

By providing an HR coating for reflecting harmonic waves on the incident end face **507** of the polarization inversion type waveguide element **506**, the harmonic wave obtained by converting the light fed back from the outgoing end face **508** to the semiconductor laser **501** is also reflected by the incident end face **507** so as to be obtained through the outgoing end face **508**, thereby achieving an even higher efficiency.

By further providing a coating having a reflectance of 97% and a coating having a reflectance of 99.9% on the incident end face **507** and the outgoing end face **508**, respectively, a waveguide-type external resonator can be constructed, which would increase the conversion efficiency to be twenty times as large.

Usually, an AR coating which does not reflect laser light generated from a semiconductor laser is provided on an end face of a polarization inversion type waveguide element. However, it is difficult to maintain the reflectance of the end face below about 0.1%. Even if the reflectance of the end face is reduced to about 0.1%, the longitudinal mode of the semiconductor laser may become unstable due to a small amount of light reflected by the end face, which amount of light is fed back to the semiconductor laser. The present example effectively utilizes the returned light due to the reflection so as to stabilize the longitudinal mode of the semiconductor laser. Therefore, the present example has considerable practical significance.

The $\lambda/2$ plate **504** disposed in the optical system (including a collimating lens **502** and a focusing lens **505**) may alternatively be formed on the thin film optical element **503**. In that case, the number of the component elements of the short wavelength light source apparatus would be reduced, thereby facilitating further miniaturization of the short wavelength light source apparatus. Moreover, by providing a rotation mechanism and a feedback circuit for the thin film optical element **503**, the harmonic output power can be stabilized.

### Example 6

Although the polarization inversion type waveguide element **506** including a substrate composed of $LiTaO_3$(LT) is used as an optical wavelength converting element in the short wavelength light source apparatus shown in Figure 5, similarly stable short wavelength light can be obtained by using a polarization inversion type waveguide element including a substrate composed of $LiNbO_3$(LN) or $KTiOPO_4$(KTP), a phase matching type waveguide device composed of KN, etc., or the like. In this case, too, it is preferable to provide an AR coating which does not reflect light having a wavelength of 870 nm and an HR coating for reflecting light having a wavelength of 870 nm on, respectively, an incident end face and an outgoing face of the optical wavelength converting element.

### Example 7

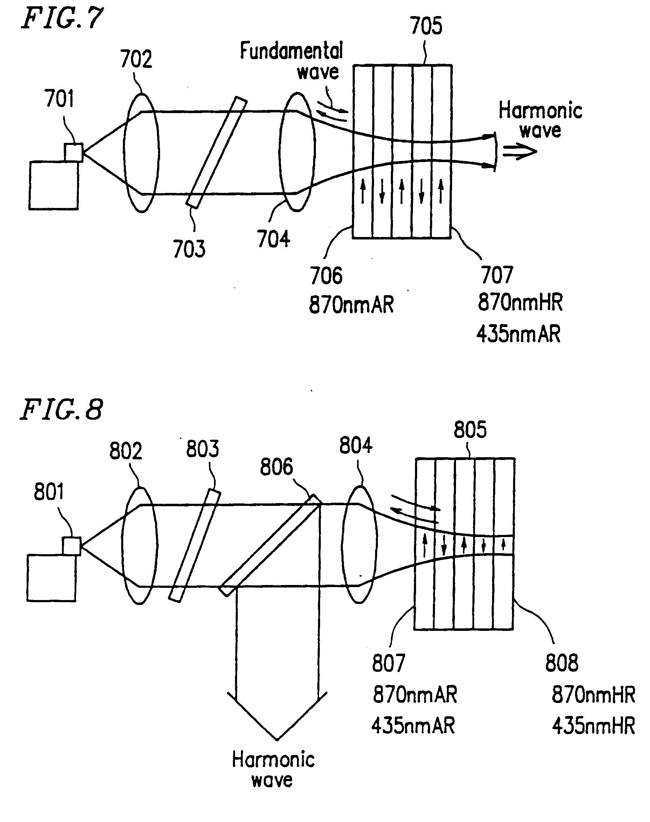

Hereinafter, a short wavelength light source apparatus according to a seventh example of the present invention will be described with reference to Figure **6**. The short wavelength light source apparatus of the present example incorporates a thin film optical element **603** (band-pass type filter) having a transmission spectrum shown in Figure **4**. A polarization inversion type waveguide element **606** is used as an optical wavelength converting element.

The semiconductor laser **601** is a 150 mW-class single longitudinal mode laser with an oscillation wavelength of the 870 nm band. Reference numeral **602** denotes a collimating lens (N.A.: 0.55); **604** denotes a $\lambda/2$ plate; and **605** denotes a focusing lens for coupling light to the waveguide. A wavelength selection mirror **607** is an optical element for separating a harmonic wave obtained by wavelength conversion from the fundamental light.

The polarization inversion type waveguide element **606** includes polarization-inverted layers (period: 4 $\mu$m) formed in a $LiTaO_3$ substrate, and an optical waveguide (width: 4 $\mu$m) as in Example 1. In the present example, an HR coating for reflecting the fundamental wave (wavelength: 870 nm) and a harmonic wave (wavelength: 435 nm) is provided on an end face **609** of the polarization inversion type waveguide element **606**. An AR coating which reflects neither light having a wavelength of 870 nm nor light having a wavelength of 435 nm is provided on an incident end face **608** of the polarization inversion type waveguide element **606** so as to reduce the reflectance of the incident end face **608**.

Laser light emitted from the semiconductor laser **601** is transmitted through the thin film optical element **603**, and then focused on the incident end face **608** of the polarization inversion type waveguide element **606** by the focusing lens **605** so as to be coupled to the waveguide.

An outgoing end face of the semiconductor laser **601** and the incident end face **608** of the polarization inversion type waveguide element **606** are confocally disposed. The outgoing end face of the semiconductor laser **601** also constitutes a confocal system with the end face **609** of the polarization inversion type waveguide element **606**. As a result, light reflected by the end face **609** is all optically fed back to an active layer of the semiconductor laser **601**. If the thin film optical element **603** is not provided, the above-mentioned reflected light (returned light) may cause the semiconductor laser **601** to have mode hopping or to have a multitude of modes.

By disposing the thin film optical element **603** between the semiconductor laser **601** and the polarization inversion type waveguide element **606** at an angle of 20° with the optical axis, it is ensured that only light having a wavelength in the vicinity of 870 nm is incident to the incident end face **608** and coupled to the optical waveguide, so that only light having a wavelength in the vicinity of 870 nm which is reflected by the end face **609** is transmitted back through the thin film element **603** so as to be optically fed back to the semiconductor laser **601**. As a result, the longitudinal mode of the semiconductor laser **601** is stabilized as a single mode in the vicinity of 870 nm.

Moreover, according to the present example, an HR coating for reflecting light having a wavelength of 870 nm and light having a wavelength of 435 nm (preferably at a 100% reflectance) is provided on the end face **609**. As a result, the fundamental wave and the harmonic wave interact with each other also when being propagated backwards, i.e. from the end face **609** to the semiconductor laser **601**. Therefore, the inter-action length obtained by the polarization inversion type waveguide element **606** becomes twice as large, so that the conversion efficiency into the harmonic wave becomes four times as large.

By so adjusting the temperature of the polarization inversion type waveguide element **606** that the phase matching wavelength is tuned to be 870 nm, as in Example 5, the fundamental wave (870 nm) coupled to the polarization inversion type waveguide element **606** is converted into a harmonic wave having a wavelength of 435 nm. As a result, blue light goes out through the incident end face **608** of the polarization inversion type waveguide element **606**. The blue light is separated from the fundamental wave by the wavelength selection mirror **607**. The polarization inversion type waveguide element **606** has a length of 10 mm and a conversion efficiency of 800%/W. As a result, a harmonic wave of about 30 mW is obtained, the fundamental wave power of about 70 mW being coupled to the waveguide.

According to the short wavelength light source apparatus of the present example, the reflectance of the end face 609 is made large. As a result, not only that the harmonic light is obtained with higher stability but also the interaction length of the optical wavelength converting element (polarization inversion type waveguide element) **606** is increased. Therefore, the present example has considerable practical significance.

The λ/2 plate **604** disposed in the optical system (including the collimating lens **602** and the focusing lens **605**) may alternatively be formed on the thin film optical element **603**. In that case, the number of the component elements of the short wavelength light source apparatus may be reduced, thereby facilitating further miniaturization of the short wavelength light source apparatus. The number of the component elements of the short wavelength light source apparatus may be further reduced and further miniaturization of the short wavelength light source apparatus would be facilitated by forming the wavelength selection mirror **607** disposed in the optical system on the thin film optical element **603**. Moreover, the harmonic output power can be stabilized by providing a rotation mechanism and a feedback circuit for the thin film optical element **603**.

Example 8

Although the polarization inversion type waveguide element **606** including a substrate composed of LiTaO$_3$(LT) is used as an optical wavelength converting element in the short wavelength light source apparatus shown in Figure **6**, similarly stable short wavelength light can be obtained by using a polarization inversion type waveguide element including a substrate composed of LiNbO$_3$(LN) or KTiOPO$_4$(KTP), a phase matching type waveguide device composed of KN, etc., or the like. In this case, too, it is preferable to provide an AR coating which reflects neither light having a wavelength of 870 nm nor light having a wavelength of 435 nm on an incident face of the optical wavelength converting element and to provide an HR coating for reflecting light having a wavelength of 870 nm and light having a wavelength of 435 nm on an outgoing face of the optical wavelength converting element.

Example 9

Hereinafter, a short wavelength light source apparatus according to a ninth example of the present invention will be described with reference to Figure **7**. The short wavelength light source apparatus of the present example incorporates a thin film optical element **703** (band-pass type filter) having a transmission spectrum shown in Figure **4**. A polarization inversion type bulk element **705** is used as an optical wavelength converting element.

The semiconductor laser **701** is a 150 mW-class single longitudinal mode laser with an oscillation wavelength of the 870 nm band. Reference numeral **702** denotes a collimating lens (N.A.: 0.55); and **704** denotes a long-focus focusing lens (N.A.: 0.2) for focusing light on the polarization inversion type bulk element **705**.

The polarization inversion type waveguide element **705** includes deep polarization-inverted layers (period: 4 μm) formed in a LiTaO$_3$ substrate by a similar manner to that used in Example 2. In the present example, the reflectance of an incident end face **706** of the polarization inversion type bulk element **705** is reduced, preferably by providing an AR coating on the incident end face **706**, so as to utilize light reflected by an outgoing end face **707** as light returning to the semiconductor laser **701**. Light emitted from the semiconductor laser

701 is focused on the outgoing end face 707 of the polarization inversion type bulk element 705. An outgoing end face of the semiconductor laser 701 and the incident end face 706 of the polarization inversion type bulk element 705 are confocally disposed. As a result, light reflected by the outgoing end face 707 is all optically fed back to an active layer of the semiconductor laser 701. If the thin film optical element 703 is not provided, the above-mentioned reflected light (returned light) may cause the semiconductor laser 701 to have mode hopping or to have a multitude of modes.

By disposing the thin film optical element 703 between the semiconductor laser 701 and the polarization inversion type bulk element 705 at an angle of 20° with the optical axis, it is ensured that only light having a wavelength in the vicinity of 870 nm is incident to the polarization inversion type bulk element 705, so that only light having a wavelength in the vicinity of 870 nm which is reflected by the outgoing end face 707 is transmitted back through the thin film element 703 so as to be optically fed back to the semiconductor laser 701. As a result, the longitudinal mode of the semiconductor laser 701 is stabilized as a single mode in the vicinity of 870 nm.

By providing an HR coating for reflecting light having a wavelength of 870 nm (preferably at a 100% reflectance) on the outgoing end face 707, the amount of light returning to the semiconductor laser 701 can be increased, so as to further stabilize the operation of the short wavelength light source apparatus.

The thin film optical element 703 is disposed obliquely with respect to the optical axis of the semiconductor laser 701. The thin film optical element 703 reflects light having wavelengths other than those in the vicinity of 870 nm. In other words, light having wavelengths other than those in the vicinity of 870 nm is not optically fed back to the active layer of the semiconductor laser 701. By adjusting the temperature of the polarization inversion type bulk element 705 so that the phase matching wavelength is tuned to be 870 nm, as in Example 5, the fundamental wave (870 nm) coupled to the polarization inversion type bulk element 705 is converted into a harmonic wave having a wavelength of 435 nm. As a result, blue light goes out through the outgoing end face 707 of the polarization inversion type bulk element 705. The polarization inversion type bulk element 705 has a length of 2 mm and a conversion efficiency of 8%/W. As a result, a harmonic wave of about 0.4 mW is obtained, the fundamental wave power of about 70 mW being coupled to the waveguide. It is preferable to provide an AR coating which does not reflect the 475 nm harmonic wave on the outgoing end face 707 of the polarization inversion type bulk element 705, so that the harmonic wave is obtained with a further increased efficiency.

Usually, an AR coating which does not reflect laser light generated from a semiconductor laser is provided on an end face of a polarization inversion type bulk element. However, it is difficult to maintain the reflectance of the end face below about 0.1%. Even if the reflectance of the end face is reduced to about 0.1%, the longitudinal mode of the semiconductor laser may become unstable due to a small amount of light reflected by the end face, which amount of light is fed back to the semiconductor laser. The present example effectively utilizes the returned light due to the reflection so as to stabilize the longitudinal mode of the semiconductor laser. Therefore, the present example has considerable practical significance.

An even higher harmonic output power can be obtained by using a 1 W-class single longitudinal mode laser including a light amplifying portion as the pump laser source.

Moreover, the harmonic output power can be stabilized by providing a rotation mechanism and a feedback circuit for the thin film optical element 703, as in Example 3.

Example 10

Although the polarization inversion type waveguide element 705 including a substrate composed of LiTaO$_3$(LT) is used as an optical wavelength converting element in the short wavelength light source apparatus shown in Figure 7, similarly stable short wavelength light can be obtained by using: a polarization inversion type bulk element including a substrate composed of LiNbO$_3$(LN) or KTiOPO$_4$(KTP); or an organic or inorganic non-linear optical crystal (a ring resonator structure, phase matching type waveguide device, etc.) having a large non-linear optical constant, e.g. KNbO$_3$(KN). In this case, too, it is preferable to provide an AR coating which does not reflect light having a wavelength of 870 nm on an incident end face of the optical wavelength converting element, and to provide an HR coating for reflecting light having a wavelength of 870 nm and an AR coating which does not reflect light having a wavelength of 435 nm on an outgoing end face of the optical wavelength converting element.

Example 11

Hereinafter, a short wavelength light source apparatus according to an eleventh example of the present invention will be described with reference to Figure 8. The short wavelength light source apparatus of the present example incorporates a thin film optical element 803 (band-pass type filter) having a transmission spectrum shown in Figure 4. A polarization inversion type bulk element 805 is used as an optical wavelength converting element.

The semiconductor laser 801 is a 150 mW-class single longitudinal mode laser with an oscillation wavelength of the 870 nm band. Reference numeral 802 denotes a collimating lens (N.A.: 0.55); and 804 denotes a long-focus focusing lens (N.A.: 0.2) for focusing light on the polarization inversion type bulk element **805**. A wavelength selection mirror **806** is an optical element for separating a harmonic wave obtained by wavelength conversion from the fundamental light.

The polarization inversion type waveguide element **805** includes deep polarization-inverted layers (period: 4 μm) formed in a LiTaO$_3$ substrate by a similar manner to that used in Example 2. An HR coating for reflecting light having a wavelength of 870 nm and light having a wavelength of 435 nm is provided on an end face **808** of the polarization inversion type bulk element **805**. The reflectance of an incident end face **807** of the polarization inversion type bulk element **805** is reduced by providing an AR coating which reflects neither light having a wavelength of 870 nm nor light having a wavelength of 435 nm thereon. Light emitted from the semiconductor laser **801** is led through the thin film optical element **803** so as to be focused by the focusing lens **804** on the end face **808** of the polarization inversion type bulk element **805**. An outgoing end face of the semiconductor laser **801** and the end face **808** of the polarization inversion type bulk element **805** are confocally disposed. As a result, light reflected by the end face **808** is optically fed back to an active layer of the semiconductor laser **801**. If the thin film optical element **803** is not provided, the above-mentioned reflected light (returned light) may cause the semiconductor laser **801** to have mode hopping or to have a multitude of modes.

By disposing the thin film optical element **803** between the semiconductor laser **801** and the polarization inversion type bulk element **805** at an angle of 20° with the optical axis, it is ensured that only light having a wavelength in the vicinity of 870 nm is incident to the polarization inversion type bulk element **805**, so that only light having a wavelength in the vicinity of 870 nm which is reflected by the end face **808** is transmitted back through the thin film element **803** so as to be optically fed back to the semiconductor laser **801**. As a result, the longitudinal mode of the semiconductor laser **801** is stabilized as a single mode in the vicinity of 870 nm.

Moreover, according to the present example, an HR coating for reflecting light having a wavelength of 870 nm and light having a wavelength of 435 nm (preferably at a 100% reflectance) is provided on the end face **808**. As a result, the fundamental wave and the harmonic wave interact with each other also when being propagated backwards, i.e. from the end face **808** to the semiconductor laser **801**. Therefore, the interaction length obtained by the polarization inversion type bulk element **805** becomes twice as large, so that the conversion efficiency into the harmonic wave becomes four times as large.

By so adjusting the temperature of the polarization inversion type bulk element **805** that the phase matching wavelength is tuned to be 870 nm, as in Example 5, the fundamental wave (870 nm) coupled to the polarization inversion type bulk element **805** is converted into a harmonic wave having a wavelength of 435 nm. As a result, blue light goes out through the incident end face **807** of the polarization inversion type bulk element **805**. The blue light is separated from the fundamental wave by the wavelength selection mirror **806**. The polarization inversion type bulk element **805** has a length of 2 mm and a conversion efficiency of 32%/W. As a result, a harmonic wave of about 1.6 mW is obtained.

According to the short wavelength light source apparatus of the present example, the reflectance of the end face **808** is made large. As a result, not only that the harmonic light is obtained with higher stability but also the interaction length of the optical wavelength converting element (polarization inversion type waveguide element) **805** is increased. Therefore, the present example has a considerable practical significance.

The wavelength selection mirror **806** inserted in the optical system composed essentially of the collimating lens **802** and the focusing lens **804** may alternatively be formed on the thin film optical element **803**. In that case, the number of the component elements of the short wavelength light source apparatus would be reduced, thereby facilitating further miniaturization of the short wavelength light source apparatus.

An even higher harmonic output power can be obtained by using a 1 W-class single longitudinal mode laser including a light amplifying portion as the pump laser source.

Moreover, the harmonic output power can be stabilized by providing a rotation mechanism and a feedback circuit for the thin film optical element **803**, as in Example 3.

Example 12

Although the polarization inversion type bulk element **805** including a substrate composed of LiTaO$_3$(LT) is used as an optical wavelength converting element in the short wavelength light source apparatus shown in Figure **8**, similarly stable short wavelength light can be obtained by using: a polarization inversion type bulk element including a substrate composed of LiNbO$_3$(LN) or KTiOPO$_4$(KTP); or an organic or inorganic non-linear optical crystal (a ring resonator structure, phase matching type waveguide device, etc.) having a large non-linear optical constant, e.g. KNbO$_3$(KN). In this case, too, it is preferable to provide an AR coating which reflects neither light having a wavelength of 870 nm nor light having a wavelength of 435 nm on an incident end face of the optical wavelength converting element, and to provide an HR coating for reflecting light having a wavelength of 870 nm and light having a wavelength of 435 nm on an outgoing end face of the optical wavelength converting element.

Example 13

It is applicable to provide a transmission type filter composed essentially of a dielectric multilayer film **903** on an outgoing end of the semiconductor laser **901**, as is shown in Figure **9A**. It is also applicable to provide a transmission type filter or reflective type filter composed essentially of a dielectric multilayer film **904** on an incident end face of a polarization inversion type waveguide element **902**. In this case, too, the oscillation wavelength of the semiconductor laser **901** can be stabilized. Thus, stable wavelength conversion and harmonic light can be provided.

Hereinafter, a short wavelength light source apparatus in which a transmission type filter **A03** is provided on an incident end face of the polarization inversion type waveguide element **902** will be described with reference to Figure **10A**.

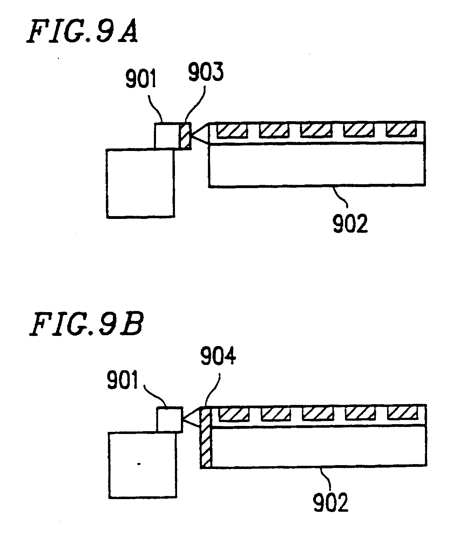

Light emitted from the semiconductor laser **A01** has an emission angle of about 2° with respect to an outgoing end face of the semiconductor laser **A01**. The outgoing end face of the semiconductor laser **A01** is disposed at a distance of about 10 μm from an incident end face of a polarization inversion type waveguide element **A02** (polarization inversion type waveguide element **A02** in Figure **9B**). The normal axis of the incident end face of the polarization inversion type waveguide element **A02** is disposed at an angle of 8° with the optical axis of the semiconductor laser **A01**. A transmission type filter **A03** has a transmittance of 80% for light having a wavelength of 870 nm which is incident thereto at an incident angle of 8°. The transmission spectrum of the transmission type filter **A03** has a width of 1 nm. Although light having a wavelength in the vicinity of 870 nm is reflected by the transmission type filter **A03**, the reflected light is not fed back to an active layer of the semiconductor laser **A01**, since the normal axis of the transmission type filter **A03** is disposed at an angle of 8° with the optical axis of the semiconductor laser **A01**. On the other hand, an optical waveguide **A04** formed in the polarization inversion type waveguide element **A02** is disposed at angle of 3.6° with the normal axis of the incident end face of the polarization inversion type waveguide element **A02**. This is so that the amount of light coupled to the waveguide **A04** becomes maximum, since light entering a material having a refractive index (n) of 2.2 at an incident angle of θ travels through the material at an angle of θ₁, the angles θ and θ₁ satisfying the following relationship:

$$\theta_1 = \sin^{-1}(\sin \theta / n) \qquad : \text{Eq. 1}$$

Thus, light coupled to the waveguide **A04** is reflected by an outgoing end face of the polarization inversion type waveguide element **A02**, led back through the transmission type filter **A03**, and fed back to the active layer of the semiconductor laser **A01**, thereby stabilizing the oscillation wavelength of the semiconductor laser **A01** at 870 nm. An HR coating for reflecting light having a wavelength of 870 nm and an AR coating which does not reflect light having a wavelength of 435 nm is provided on the outgoing end face of the polarization inversion type waveguide element **A02**. The light coupled to the waveguide **A04** is converted into light having a wavelength of 435 nm, which goes out through the outgoing end face of the polarization inversion type waveguide element **A02**.

Although no optical system is provided between the semiconductor laser **A01** and the polarization inversion type waveguide element **A02** in the short wavelength light source apparatus shown in Figure **10A**, it is applicable to provide one.

When providing a reflective type filter instead of the transmission type filter **A03**, it is preferable to dispose the optical axis of the semiconductor laser **A01** perpendicularly with respect to the incident end face of the polarization inversion type waveguide element **A02** so as to increase the efficiency with which light is coupled to the waveguide **A04**.

Although it is commonly practiced to fabricate polarization-inverted layers and a waveguide in a z-plate LiTaO₃, the polarization inversion type waveguide element **A02** shown in Figure **10A** is formed of an x-plate LiTaO₃, since such a polarization inversion type waveguide element is more preferable because of the large coupling coefficient thereof with the semiconductor laser **A01**.

The coupling efficiency between the semiconductor laser **A01** and the polarization inversion type waveguide element **A02** can be still more increased by further providing a λ/2 plate, which is commonly used for improving the coupling efficiency between a z-plate polarization inversion type waveguide element and a semiconductor laser, on the incident end face of the LiTaO₃ substrate.

By thus miniaturizing the light source, the entire device incorporating the light source can be miniaturized, and temperature control is also facilitated, thereby making the device more practical.

Similar effects can be obtained by providing a reflective type filter on the outgoing end face of the polarization inversion type waveguide element **A02**.

Example 14

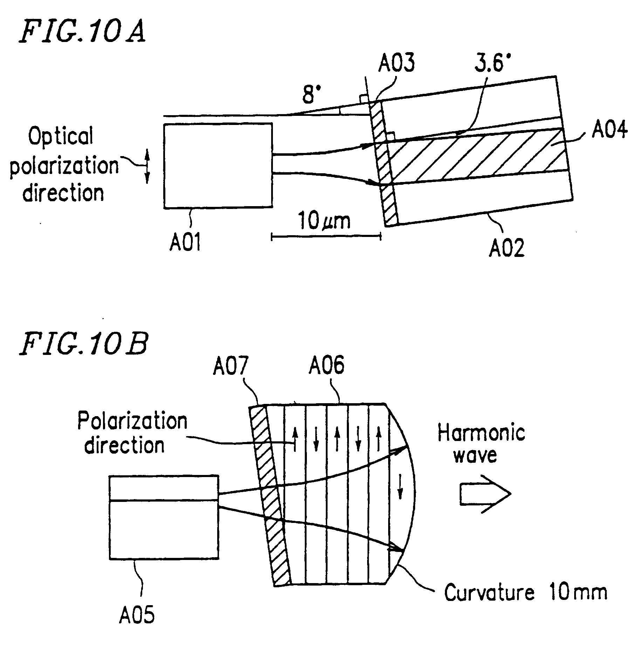

In the short wavelength light source apparatus of Example 13, the polarization inversion type waveguide element **A02** is used as an optical wavelength converting element. However, similarly stable short wavelength light can be obtained by using a polarization inversion type bulk element including a substrate composed of LiTaO₃(LT), LiNbO₃(LN) or KTiOPO₄(KTP) or a non-linear optical crystal (a ring resonator structure, phase matching type waveguide device, etc.) having a large non-linear optical constant, e.g. KNbO₃(KN), as an optical wavelength converting element, and by providing a thin film optical element on the incident end face or the outgoing end face of the optical wavelength converting element. Hereinafter, a short wavelength light source apparatus incorporating a polarization inversion type bulk element **A06** will be described with reference to Figure **10B**.

As is shown in Figure **10B**, light emitted from a semiconductor laser **A05** is incident to an incident end face of the polarization inversion type bulk element **A06** formed in a LiTaO$_3$ substrate. A transmission type filter **A07** provided on the incident end face of the polarization inversion type bulk element **A06** transmits only light having a wavelength in the vicinity of 870 nm, which light is led to an outgoing end face of the polarization inversion type bulk element **A06**. The outgoing end face of the polarization inversion type bulk element **A06** is processed to a spherical shape, and has a curvature of 10 mm. An HR coating for reflecting light having a wavelength of 870 nm and an AR coating which does not reflect light having a wavelength of 435 nm are provided on the outgoing end face of the polarization inversion type bulk element **A06**. Light reflected by the outgoing end face of the polarization inversion type waveguide element **A06** is transmitted back through the transmission type filter **A07**, and is focused on an outgoing end face of the semiconductor laser **A05** so as to be optically fed back to an active layer thereof. As a result, the oscillation wavelength of the semiconductor laser short wavelength light source apparatus is stabilized in the vicinity of 870 nm. Thus, light having a wavelength of 435 nm, obtained through a wavelength conversion by the polarization inversion type bulk element **A06** goes out through the outgoing end face of the polarization inversion type bulk element **A06**. The incident end face of the polarization inversion type bulk element **A06** has been cut out at an angle of about 8°, so that light reflected by the transmission type filter **A07** is not fed back to the semiconductor laser **A05**.

Similar effects can be obtained by further providing a reflective type filter on the outgoing end face of the polarization inversion type bulk element **A06**.

Example 15

According to a short wavelength light source apparatus of the present invention, the oscillation wavelength of a semiconductor laser can be varied by varying an angle θ at which a thin film optical element is disposed. By so configuring a polarization inversion type bulk element or waveguide element of the short wavelength light source apparatus as to have a polarization inversion period of a chirp structure or a split structure, light having short wavelengths corresponding to the varying oscillation wavelengths of the semiconductor laser can be obtained. In other words, the wavelength of the short wavelength light can be tuned by varying the incident angle of laser light at which the laser light enters the thin film optical element.

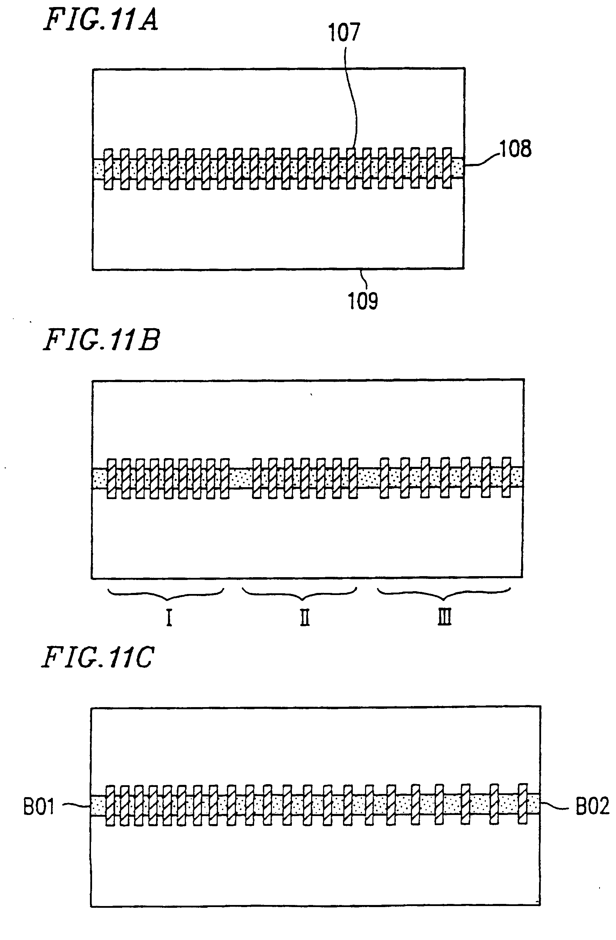

Figure **11A** shows the polarization inversion type waveguide element **106** shown in Figure **1**. In the polarization inversion type waveguide element **106**, the first order polarization-inverted layers **107** having a period of 4.0 μm are uniformly formed in the LiTaO$_3$ substrate **109** so that quasi-phase matching is achieved for light having a wavelength of 870 nm. Figure **11B** shows a polarization inversion type waveguide element having a split structure. The polarization inversion type waveguide element shown in Figure **11B** is 15 mm long. The polarization inversion type waveguide element is divided into three regions **I**, **II**, and **III**. Each region is 5 mm long. The polarization-inverted layers in region **I** have a period of 3.6 μm; the polarization-inverted layers in region **II** have a period of 3.8 μm; and the polarization-inverted layers in region **III** have a period of 4.0 μm. Quasi-phase matching is achieved for light having wavelengths of 850 nm, 860 nm, and 870 nm in regions **I**, **II**, and **III**, respectively. Regions **I**, **II**, and **III** output harmonics having wavelengths of, respectively, 425 nm, 430 nm, and 435 nm.

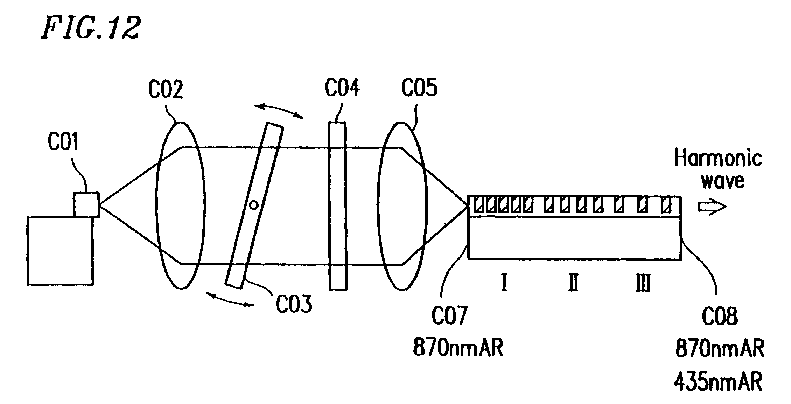

Figure **12** shows a short wavelength light source apparatus incorporating a polarization inversion type waveguide element **C06** which is identical with the polarization inversion type waveguide element shown in Figure **11B**. Reference numeral **C01** denotes a 150 mW-class single longitudinal mode semiconductor laser; **C02** denotes a collimating lens (N.A.: 0.55); **C03** denotes a thin film optical element; **C04** denotes a λ/2 plate; and **C05** denotes a focusing lens for coupling light to a waveguide formed in the polarization inversion type waveguide element. The thin film optical element **C03** is a band-pass filter composed essentially of a dielectric multilayer film having a transmittance of about 85%, and has a transmission spectrum with peak wavelengths of 870 nm, 860 nm, and 850 nm at incident angles of 1°, 15°, and 20°, respectively. The wavelength of the output harmonic wave can be varied by adjusting the angle θ at which the thin film optical element **C03** shown in Figure **12** is disposed. The polarization inversion type waveguide element **C06** includes an optical waveguide (width: 4 μm) and the polarization-inverted layers shown in Figure **11B** formed in a LiTaO$_3$ substrate.

An HR coating for reflecting light having a wavelength in the range of 850 nm to 870 nm is provided on an outgoing end face **C08** of the polarization inversion type waveguide element **C06**. An AR coating which does not reflect light having a wavelength in the range of 850 nm to 870 nm is provided on an incident end face **C07** of the polarization inversion type waveguide element **C06**.

Light emitted from the semiconductor laser **C01** is focused by the focusing lens **C05** on the incident end face **C07** of the polarization inversion type waveguide element **C06** so as to be coupled to the waveguide. An outgoing end face of the semiconductor laser **C01** and the incident end face **C07** of the polarization inversion type element **C06** are confocally disposed. The outgoing end face of the semiconductor laser **C01** also constitutes a confocal system with the outgoing end face **C08** of the polarization inversion type waveguide element **C06**. As a result, light reflected by the outgoing end face **C08** is all optically fed back to an active layer of the semiconductor laser **C01**. If the thin film optical element **C03** is not provided, the above-mentioned reflected light (returned light) may cause the semiconductor laser **C01** to have mode hopping or to have a multitude of modes.

By disposing the thin film optical element **C03** between the semiconductor laser **C01** and the polarization inversion type waveguide element **C06** at a certain angle with the optical axis, it is ensured that only light having a corresponding wavelength in a narrow range of band from 850 nm to 870 nm, emitted from the semiconductor laser **C01**, is incident to the incident end face **C07** of the polarization inversion type waveguide element **C06**, so that only light having that wavelength which is reflected by the outgoing end face **C08** is optically fed back to the semiconductor laser **C01**. As a result, the semiconductor laser **C01** stably oscillates in a single longitudinal mode, the oscillation wavelength being stabilized.

By rotating the thin film optical element **C03** so that the oscillation wavelength of the semiconductor laser **C01** coincides with the phase matching wavelengths of the respective split regions **I**, **II**, and **III**, the oscillation wavelength can be made to coincide with the respective phase matching wavelengths of 850 nm, 860 nm, and 870 nm. As a result, the laser light is converted into light having wavelengths of 425 nm, 430 nm, or 435 nm, which is obtained through the outgoing end face **C08** of the polarization inversion type waveguide element **C06**. As a result, a harmonic wave of about 2.5 mW is obtained at each wavelength, the fundamental wave power of about 70 mW being coupled to the waveguide. An AR coating for reflecting harmonics is provided on the outgoing end face **C08** of the polarization inversion type waveguide element **C06**.

As a rotation mechanism for rotating the thin film optical element **C03**, a rotation monitor and/or a piezo element may be used. The output power of the short wavelength light source apparatus can be stabilized by monitoring the harmonic output power and feeding back the monitored harmonic output power to the rotation mechanism.

Figure **11C** shows a polarization inversion type waveguide element having a chirp structure. The polarization inversion type waveguide element is 15 mm long. The polarization-inverted layers have a period of 3.6 μm at an end face **01**, and a period of 4.0 μm at an end face **B02**, thus providing a linear chirp structure. This polarization inversion type waveguide element can be substituted for the polarization inversion type waveguide element **C06** in the polarization inversion type waveguide element **C06** shown in Figure **12**. In that case, the wavelength of the output harmonic wave can be continually varied by varying the angle θ at which the thin film optical element **C03** is disposed from 0° to 20°.

Although light reflected by the outgoing end face **C08** of the polarization inversion type waveguide element **C06** is optically fed back to the semiconductor laser **C01** in the short wavelength light source apparatus shown in Figure **12**, a wavelength-variable short wavelength light source apparatus can also be realized by optically feeding back light reflected by the incident end face **C07**, as is shown in Figure **3**.

A short wavelength light source apparatus having four times as large an harmonic output power as that of the short wavelength light source apparatus shown in Figure **12** can be realized by providing an HR coating for reflecting the fundamental wave and the harmonic wave and by extracting the harmonic wave by means of a wavelength selection mirror.

The wavelength-variable short wavelength light source apparatus according to the present example, capable of generating light in the blue wavelength band, has much use in the fields of measurement and communication as well as a wide range of applicability.

<u>Example 16</u>

Although the polarization inversion type waveguide element **C06** is used as an optical wavelength converting element in the short wavelength light source apparatus shown in Figure **12**, a similar wavelength-variable short wavelength light source apparatus can be realized by using a polarization inversion type bulk element having a split structure or a chirp structure. It is also applicable to use a $LiNbO_3$ or KTP substrate instead of a $LiTaO_3$ substrate.

<u>Example 17</u>

Although a transmission type filter is used as a thin film optical element in the short wavelength light source apparatus shown in Figure **12**, a similar wavelength-variable short wavelength light source apparatus can be realized by using a reflective type filter.

<u>Example 18</u>

The phase matching wavelength of a polarization inversion type waveguide element can be adjusted by varying the refractive index of the substrate of the polarization inversion type waveguide element through temperature control or application of an electric field. The wavelength of the output harmonic light can be varied by adjusting the phase matching wavelength of the polarization inversion type waveguide element.

A short wavelength light source apparatus according to the present example is identical with that shown in Figure **12** except for the configuration of the optical wavelength converting element. The optical wavelength converting element of the present example is a polarization inversion type waveguide element including an optical waveguide (width: 4 $\mu$m) and polarization-inverted layers (period: 3.8 $\mu$m) formed in a LiTaO$_3$ substrate. A thin film resistor is formed on the optical waveguide. By varying the temperature of the polarization inversion type waveguide element with the use of the thin film resistor, the phase matching wavelength can be adjusted to be any value in the range of 850 nm to 870 nm.

An HR coating for reflecting light having a wavelength in the range of 850 nm to 870 nm, and an AR coating which does not reflect harmonic waves are provided on an outgoing end face of the polarization inversion type waveguide element. An AR coating which does not reflect light having a wavelength in the range of 850 nm to 870 nm is provided on an incident end face of the polarization inversion type waveguide element.

By adjusting the phase matching wavelength to be a desired value in the range of 850 nm to 870 nm and by tuning the oscillation wavelength of the semiconductor laser to be the phase matching wavelength, a harmonic light having a desired wavelength in the range of 425 nm to 435 nm is obtained through the outgoing end face of the polarization inversion type waveguide element. As a result, a harmonic wave of about 10 mW is obtained, laser light of about 70 mW being coupled to the waveguide. In cases where a thin film electrode is formed on the waveguide, instead of the thin film resistor, the phase matching wavelength of the polarization inversion type waveguide element can be varied by varying the applied voltage.

The wavelength-variable short wavelength light source apparatus according to the present example, capable of generating light in the blue wavelength band, has much use in the fields of measurement and communication as well as a wide range of applicability.

Example 19

The oscillation wavelength of a semiconductor laser of a short wavelength light source apparatus according to the present invention can also be adjusted to be the phase matching wavelength of the polarization inversion type waveguide element by using a Bragg's reflective type thin film optical element composed essentially of a plurality of periodically formed layers.

A method for producing a Bragg's reflective type thin film optical element will be described. SiO$_2$ (refractive index: 1.46), SiO$_2$ having a different composition (refractive index: 1.48) are alternately formed with a period of 0.27 $\mu$m on a quartz substrate by means of an EB vapor deposition apparatus. About 100 such layers are laminated to form the Bragg's reflective type thin film optical element. A Bragg's reflective type thin film optical element is very practical because the spectrum width thereof can be easily adjusted by varying the number of the layers laminated. The oscillation wavelength of a semiconductor laser of a short wavelength light source apparatus incorporating this Bragg's reflective type thin film optical element instead of the band-stop filter shown in Figure 1 is stabilized at the phase matching wavelength. A stable harmonic output power can be obtained without any mode hopping.

In the above-mentioned example, the Bragg's reflective type thin film optical element is formed on a quartz substrate so as to form a separate optical element. However, similar effects can be attained by forming a Bragg's reflective type thin film optical element directly on an incident end face or an outgoing end face of the polarization inversion type waveguide element, as shown in Figure 10, or on an outgoing end face of the semiconductor laser, thus providing a stable blue/green light source apparatus.

A Bragg's reflective type filter can also be realized by a holographical method where laser light of a predetermined wavelength is incident to a photorefractive material such as LT and LN doped with Fe in two directions so that the two laser light beams interfere with each other.

Example 20

Each of the transmission type or reflective type filters shown in Figures 1, 3, 5, 6, 7, 8, 12, and 13 is a thin film optical element obtained by forming a dielectric multilayer film on a glass substrate having a thickness of 0.5 mm. It was found out that the oscillation wavelength becomes especially stable when the glass substrate has a thickness in the range of 0.2 mm to 2.0 mm. The oscillation wavelength becomes unstable when the thickness of the substrate is 0.2 mm or less because of the warping of the substrate after polishing. The oscillation wavelength has an aberration when the thickness of the substrate is 2.0 mm or more owing to the thickness of the substrate.

Example 21

In the examples shown in Figures 1, 3, 5, 6, 7, 8, 12, and 13, a thin film optical element including a dielectric multilayer film formed on a glass substrate is used as an optical element for transmitting or reflecting light in a predetermined wavelength band. The longitudinal mode of the semiconductor laser can also be locked and stabilized by using the following as an optical element: an etalon element including a highly planar element polished so as to be highly planar and so as to have a high degree of parallelism and a reflective film formed on each side of the highly planar element; or a birefringence filter that utilizes interference between normal light and extraordinary light in a birefringence crystal plate.

Hereinafter, an etalon element will be described. Etalon composed of synthetic quartz having a thickness of 50 $\mu$m, a reflectance of 85%, and a parallelism of $\lambda$/10 is used in the present example. Etalon has peak transmittances at certain intervals when transmittance is regarded as a function of the wavelength of incident light. The interval $\Delta v$ between modes is derived from the following equation:

$$\Delta v = \lambda^2 / (2nL) \qquad :Eq.\ 2$$

wherein n represents the refractive index of the material, and L represents the thickness of the material. In the present example, $\Delta v$ is 5 nm. Next, finesse F of the etalon is derived. The finesse F is expressed as a ratio between $\Delta v$ and the half width $\Delta v_{1/2}$ of a certain mode. The finesse F is determined by such factors as reflectance (reflection finesse), degree of planarity and degree of parallelism (planarity finesse), and coarseness of the plane, as is expressed by the following equation:

$$1 / F^2 = (1 / F_r^2) + (1 / F_d^2) \qquad :Eq.\ 3$$

wherein $F_r^2$ represents the reflection finesse, and $F_d^2$ represents the planarity finesse. The reflection finesse $F_r^2$ and the planarity finesse $F_d^2$ are expressed by the following equations:

$$F_r^2 = \pi^2 R / (1 - R)^2 \qquad :Eq.\ 4$$

$$F_d = S / 2 \qquad :Eq.\ 5$$

wherein R represents the reflectance, and S is a value obtained by dividing $\lambda$ by the degree of parallelism of the etalon. The finesse F of the etalon of the present example is 5. The half width $\Delta v_{1/2}$ of the etalon of the present example is derived to be 1 nm from the following equation:

$$\Delta v_{1/2} = \Delta v / F \qquad :Eq.\ 6$$

The value 1 nm of the half width of the etalon of the present example is substantially the same as that of a transmission type filter (thin film optical element). By disposing this etalon between a semiconductor laser and an optical wavelength converting element, the longitudinal mode of the semiconductor laser is stabilized as a single mode. Moreover, the oscillation wavelength of the semiconductor laser becomes stable by increasing the reflectance and the degree of planarity of the etalon so that the half width $\Delta v_{1/2}$ further reduces.

Next, a birefringence filter will be described. An interference pattern can be obtained by radiating light on a crystal panel interposed between two polarizing plates, corresponding to the change in the wavelength of the incident light. By laminating several layers of such composites each composed of a crystal plate interposed between polarizing plates (so that the thickness of the multilayer varies from d to 2d, 4d, .., etc.), the interference patterns overlap with one another so that a sharp peak is left. Thus, a band-pass filter having a transmission spectrum width of about 0.1 nm is realized. The oscillation wavelength of the semiconductor laser can be stabilized also by using such a birefringence filter in the place of a thin film optical element.

As has been described, according to the present invention, a compact, stable, and high-power short wavelength light source apparatus for generating green or blue light is provided which incorporates as a pump light source a light generating device including an optical element for transmitting or reflecting light in a predetermined wavelength band, and a polarization inversion type waveguide element, a polarization inversion type bulk element, and/or a non-linear optical crystal for converting light emitted from the semiconductor laser into light having a different wavelength. A short wavelength light source apparatus according to the present invention is also capable of providing near infrared light by incorporating a laser medium, and providing stable short wavelength light by adopting an intracavity configuration. Thus, the present invention has a large practical significance because it can provide a short wavelength light source apparatus to be used for an optical disk or for measurement purposes, where the short wavelength light source apparatus is required to have a stable, low-noise output power.

Generally, a short wavelength light source apparatus incorporating a semiconductor laser is likely to have the problem of unstable oscillation by the semiconductor laser due to light returning from an end face of an optical wavelength converting element or an end face of a laser medium. However, by using the above-mentioned optical element, light returning (reflected) from such end faces can be utilized for stabilizing the oscillation wavelength of the semiconductor laser, which makes a short wavelength light source apparatus of the present invention very practical. Moreover, the optical component elements can be linearly disposed, thereby facilitating miniaturization of the short wavelength light source apparatus.

A peak wavelength of the transmission spectrum of a transmission type filter (thin film optical element) generally has angle dependence. When the incident light enters at an angle of 20° with the optical axis, the peak wavelength of the transmission spectrum shifts by 1.5 nm/deg. When the incident angle is in the vicinity of 10°, the shift amount is 0.9 nm/deg. When the incident angle is 0°, the peak wavelength makes substantially no shift depending on the angle. Taking advantage of the angle dependence of the filter, the oscillation wavelength of the semiconductor laser can be tuned to be the phase matching wavelength of the optical wavelength converting element. On the other hand, the shift amount of the transmission spectrum of a transmission filter is not so large as compared with that of a grating, e.g. 28 nm/deg. Therefore, using a transmission type filter to stabilize the oscillation wavelength of the semiconductor laser makes the necessary optical adjustment easier than using grating feedback technique. It will be appreciated that use of a transmission type filter (thin film optical element) for stabilization of the oscillation wavelength of the semiconductor laser has great practical effects.

Moreover, a short wavelength light source apparatus according to the present invention is stable against temperature changes, having a wavelength shift of 0.005 nm/°C, and is also stable against changes in moisture. Since it is not composed of resin unlike a grating, the entire short wavelength light source apparatus is made reliable.

Since thin film optical elements are produced by vapor deposition, a mass-production effect is provided, which increases the practicality of the short wavelength light source apparatus.

Even more stable oscillation wavelength (oscillation wavelength locking) can be achieved by incorporating an etalon or a birefringence filter, since the half width of the transmission spectrum of such elements can be reduced to about 0.1 nm.

By providing a rotation mechanism such as a piezo element or a motor (actuator) on the filter and by conducting a feedback so as to stabilize the output power of the short wavelength light, it becomes possible to obtain an output power which is stable against changes in the refractive index due to temperature changes of the optical wavelength converting element and/or optical damage, i.e. changes in the phase matching wavelength, thereby making the short wavelength light source apparatus very practical.

Various other modifications will be apparent to and can be readily made by those skilled in the art without departing from the scope of this invention. Accordingly, it is not intended that the scope of the claims appended hereto be limited to the description as set forth herein, but rather that the claims be broadly construed.

**Claims**

1. A short wavelength light source apparatus comprising:

   - a semiconductor laser (101) including an active layer for emitting laser light;
   - an optical wavelength converting element (106) for receiving at least a portion of the laser light emitted from the semiconductor laser (101) and for generating short wavelength light having a wavelength shorter than the wavelength of the laser light; and
   - an optical element (103) disposed between the semiconductor laser (101) and the optical wavelength converting element (106) for selectively reflecting a portion of the laser light that belongs to a predetermined wavelength band and for feeding back the reflected light to the active layer of the semiconductor laser (101) so as to achieve stable oscillation in a single longitudinal mode,

   characterized in that

   - the optical element (103) is a thin film optical element (103) comprising dielectric layers,
   - the optical wavelength converting element (106) is a quasi-phase-matching (QPM) type polarization inversion element having a waveguide, and
   - the polarization direction of the laser light emitted from the semiconductor laser (101) is set to coincide with the polarization direction of said waveguide of the optical wavelength converting element (106).

2. A short wavelength light source apparatus according to claim 1, wherein the optical wavelength converting element (106) is formed in a $LiNb_xTa_{1-x}O_3$ ($0 \leq x \leq 1$) substrate or a $K_{1-x}Rb_xTiOM0_4$ ($0 \leq x \leq 1$; M = P or As ) substrate.

3. A short wavelength light source apparatus according to one of claims 1 or 2, wherein the optical element (103) is a Bragg's reflective type thin film optical element comprising dielectric layers having different refractive indices, the dielectric layers being formed with a predetermined period.

4. A short wavelength light source apparatus according to one of claims 1 or 2, wherein the optical element is a thin film optical element (103) including a substrate and a dielectric multilayer film formed on the substrate.

5. A short wavelength light source apparatus according to one of claims 1 or 2, wherein the optical element (103) comprises a dielectric multilayer film (303) formed on an incident end face or an outgoing end face of at least one of the semiconductor laser (101) and the optical wavelength converting element (106).

6. A short wavelength light source apparatus according to one of claims 1 to 5 further comprising more than one optical element beside the thin film optical element (103).

7. A short wavelength light source apparatus according to one of the preceding claims, wherein the optical element (103) includes a thin film (304) functioning as a $\lambda/2$ plate for the wavelength of the laser light.

8. A short wavelength light source apparatus according to one of the preceding claims, wherein a $\lambda/2$ plate (104) is located between the semiconductor laser (101) and the QPM type polarization inversion element (106).

9. A short wavelength light source apparatus comprising:

- a semiconductor laser (301) including an active layer for emitting laser light;
- an optical wavelength converting element (306) for receiving at least a portion of the laser light emitted from the semiconductor laser (301) and for generating short wavelength light having a wavelength shorter than the wavelength of the laser light,
- wherein the optical wavelength converting element (306) has an incident end face (307) for receiving at least a portion of the laser light and an outgoing end face through which the short wavelength light goes out; and
- an optical element (303) disposed between the semiconductor laser (301) and the optical wavelength converting element (306); characterized in that
- the optical element (303) is a thin film optical element (303) comprising dielectric layers for selectively transmitting a portion of the laser light that belongs to a predetermined wave length band; that
- the optical wavelength converting element is a quasi-phase-matching (QPM) type polarization inversion element having a waveguide;
- the semiconductor laser (301) and the optical wave length converting element (306) being disposed in such a manner that the portion of the laser light transmitted through the optical element (303) is reflected by the incident end face (307) of the optical wavelength converting element (306) so as to be transmitted back through the thin film optical element (303) and fed back to the active layer of the semiconductor laser (301) so as to achieve stable oscillation in a single longitudinal mode, and that
- the polarization direction of the laser light emitted from the semiconductor laser (301) is set to coincide with the polarization direction of said waveguide of the optical wavelength converting element (306).

10. A short wavelength light source apparatus according to claim 9, wherein the optical wavelength converting element is formed in a $LiNb_xTa_{1-x}O_3$ ($0 \leq x \leq 1$) substrate or a $K_{1-x}Rb_xTiOMO_4$ ($0 \leq x \leq 1$; M = P or As ) substrate.

11. A short wavelength light source apparatus according to claim 9, wherein the optical wavelength converting element is divided into a plurality of regions having different polarization inversion periods from one another.

12. A short wavelength light source apparatus according to claim 11, wherein the wavelength of light incident to the optical wavelength converting element is adjusted to be a phase matching wavelength of the optical wavelength converting element by varying the angle of the optical element, whereby the wavelength of the short wavelength light is varied.

13. A short wavelength light source apparatus according to claim 9, wherein the optical wavelength converting element has a chirp structure having a varying polarization inversion period.

14. A short wavelength light source apparatus according to claim 13, wherein the wavelength of light incident to the optical wavelength converting element is adjusted to be a phase matching wavelength of the optical wavelength converting element by varying the angle of the optical element, whereby the wavelength of the short wavelength light is varied.

15. A short wavelength light source apparatus according to one of claims 9 to 14, wherein the optical element (503) is a thin film optical element including a substrate and a dielectric multilayer film formed on the substrate.

16. A short wavelength light source apparatus according to one of claims 9 to 14, wherein the optical element comprises a dielectric multilayer film formed on an incident end face or an outgoing end face of at least one of the semiconductor laser and the optical wavelength converting element.

17. A short wavelength light source apparatus according to one of claims 9 to 14, wherein the optical element is disposed at an angle with an optical axis of the semiconductor laser.

18. A short wavelength light source apparatus according to one of claims 9 to 15 further comprising a rotation mechanism for rotating the optical element (503).

19. A short wavelength light source apparatus according to claim 18 further comprising means for varying a phase matching wavelength of the optical wavelength converting element (506), wherein a wavelength of light incident to the optical wavelength converting element (506) is adjusted to be the phase matching wavelength by varying the angle of the optical element, whereby the wavelength of the short wavelength light is varied.

20. A short wavelength light source apparatus according to claim 18, wherein the wavelength of light incident to the optical wavelength converting element (506) is adjusted to be a phase matching wavelength of the optical wavelength converting element (506) by varying the angle of the optical element (503), whereby the wavelength of the short wavelength light is varied.

21. A short wavelength light source apparatus according to claim 18, wherein the rotation mechanism includes a feedback circuit for controlling the output power of the short wavelength light to be constant.

22. A short wavelength light source apparatus according to claim 18, wherein the rotation mechanism includes a piezo element.

23. A short wavelength light source apparatus according to claim 18, wherein the rotation mechanism includes an actuator.

24. A short wavelength light source apparatus according to one of claims 9 to 23 further comprising more than one optical element besides the optical element.

25. A short wavelength light source apparatus according to claim 18, wherein the rotation mechanism includes a thin film functioning as a $\lambda/2$ plate for the wavelength of the laser light.

26. A short wavelength light source apparatus according to claims 9 to 24, wherein a $\lambda/2$ plate (304) is located between the semiconductor laser (301) and the element (306).

27. A short wavelength light source apparatus comprising:
a semiconductor laser (501) including an active layer for emitting laser light; and an optical wavelength converting element (506) for receiving at least a portion of the laser light emitted from the semiconductor laser (501) and for generating short wavelength light having a wavelength shorter than a wavelength of the laser light,

- wherein the optical wavelength converting element (506) has an incident end face (507) for receiving at least a portion of the laser light and an outgoing end face (508) through which the short wavelength light goes out; and
- an optical element (503) disposed between the semiconductor laser (501) and the optical wavelength converting element (506), characterized in that
- the optical wavelength converting element (506) is a quasi-phase-matching (QPM) type polarization inversion element having a waveguide,
- the optical element (503) is a thin film optical element comprising dielectric layers for selectively transmitting a portion of the laser light that belongs to a predetermined wavelength band, the semiconductor laser (501) and the optical wavelength converting element (506) being disposed in such a manner that the portion of the laser light transmitted through the thin film optical element (503) enters the optical wavelength converting element (506) at the incident end face (507) thereof and thereafter is reflected by the outgoing end face (508) of the optical wavelength converting element (506) so as to be transmitted back through the thin film optical element (503) and fed back to the active layer of the semiconductor laser (501) so as to achieve stable oscillation in a single longitudinal mode, and

- the polarization direction of the laser light emitted from the semiconductor laser (501) is set to coincide with the polarization direction of said waveguide of the optical wavelength converting element (506).

28. A short wavelength light source apparatus according to claim 27, wherein the optical wavelength converting element (506) is formed in a $LiNb_xTa_{1-x}O_3$ $(0 \leq x \leq 1)$ substrate or a $K_{1-x}Rb_xTiOMO_4$ $(0 \leq x \leq 1; M = P \text{ or } As)$ substrate.

29. A short wavelength light source apparatus according to claim 27, wherein the optical wavelength converting element (506) is divided into a plurality of regions having different polarization inversion period from one another.

30. A short wavelength light source apparatus according to claim 29, wherein the wavelength of light incident to the optical wavelength converting element (506) is adjusted to be a phase matching wavelength by varying the angle of the optical element, whereby the wavelength of the short wavelength light is varied.

31. A short wavelength light source apparatus according to claim 27, wherein the optical wavelength converting element (506) has a chirp structure having a varying polarization inversion period.

32. A short wavelength light source apparatus according to claim 31, wherein the wavelength of light incident to the optical wavelength converting element is adjusted to be a phase matching wavelength of the optical wavelength converting element by varying the angle of the optical element, whereby the wavelength of the short wavelength light is varied.

33. A short wavelength light source apparatus according to one of claims 27 to 32, wherein the optical element is a thin film optical element (503) including a substrate and a dielectric multilayer film formed on the substrate.

34. A short wavelength light source apparatus according to one of claims 27 to 32, wherein the optical element (503) comprises a dielectric multilayer film formed on an incident end face or an outgoing end face of at least one of the semiconductor laser (501) and the optical wavelength converting element (506).

35. A short wavelength light source apparatus according to one of claims 27 to 32, wherein the optical element (503) is disposed at an angle with the optical axis of the semiconductor laser (501).

36. A short wavelength light source apparatus according to one of claims 27 to 35 further comprising a rotation mechanism for rotating the optical element (503).

37. A short wavelength light source apparatus according to claim 36 further comprising means for varying a phase matching wavelength of the optical wavelength converting element, wherein the wavelength of light incident to the optical wavelength converting element is adjusted to be the phase matching wavelength by varying the angle of the optical element, whereby the wavelength of the short wavelength light is varied.

38. A short wavelength light source apparatus according to claim 36, wherein the wavelength of light incident to the optical wavelength converting element is adjusted to be a phase matching wavelength of the optical wavelength converting element by varying the angle of the optical element, whereby the wavelength of the short wavelength light is varied.

39. A short wavelength light source apparatus according to claim 36, wherein the rotation mechanism includes a feedback circuit for controlling the output power of the short wavelength light to be constant.

40. A short wavelength light source apparatus according to claim 36, wherein the rotation mechanism includes a piezo element.

41. A short wavelength light source apparatus according to claim 36, wherein the rotation mechanism includes an actuator.

42. A short wavelength light source apparatus according to one of claims 27 to 41, further comprising more than one optical element beside the thin film optical element.

43. A short wavelength light source apparatus according to one of claims 27 to 42, wherein the thin film optical element (603) includes a thin film (604) functioning as a $\lambda/2$ plate for the wavelength of the laser light.

44. A short wavelength light source apparatus according to one of claims 27 to 42, wherein a $\lambda/2$ plate (504) is located between the semiconductor laser (501) and the element.

45. A short wavelength light source apparatus comprising:

   - a semiconductor laser (601) including an active layer for emitting laserlight;
   - an optical wavelength converting element (606) for receiving at least a portion of the laser light emitted from the semiconductor laser (601) and for generating short wavelength light having a wavelength shorter than the wavelength of the laser light,
   - wherein the optical wavelength converting element (606) includes a waveguide and has an incident end face (680) for receiving at least a portion of the laser light and an outgoing end face (608), and
   - an optical element (603) disposed between the semiconductor laser (601) and the optical wavelength converting element (605), characterized in that
   - the optical wavelength converting element is a quasi-phase-matching (QPM) type polarization inversion element,
   - the optical element is a thin film optical element (603) comprising dielectric layers for selectively transmitting a portion of the laser light that belongs to the predetermined wavelength band,
   - a wavelength selection mirror (607) is provided for selectively transmitting a portion of the laser light that belongs to a predetermined wavelength band and for reflecting the short wavelength light, the wavelength selection mirror (606) being disposed between the semiconductor laser (601) and the optical wavelength converting element (606), and
   - a portion of the laser light that belongs to the predetermined wavelength band is transmitted through the thin film optical element (603) and the wavelength selection minor (606), reflected by the incident end face (680) of the optical wavelength converting element (606), and thereafter is transmitted back through the thin film optical element (603) and the wavelength selection mirror (606) so as to be fed back to the active layer of the semiconductor laser (601) in order to achieve stable oscillation in a single longitudinal mode,
   - the short wavelength light generated by the optical wavelength converting element (606) is reflected by the outgoing end face (680) of the optical wavelength converting element (606), propagated back through the waveguide, and thereafter is reflected in a predetermined direction by the wavelength selection mirror (607), and

- the polarization direction of the laser light emitted from the semiconductor laser (601) is set to coincide with the polarization direction of a waveguide of the optical wavelength converting element (605).

46. A short wavelength light source apparatus according to claim 45, wherein the optical wavelength converting element (605) is formed in a $LiNb_xTa_{1-x}O_3$ ($0 \leq x \leq 1$) substrate or a $K_{1-x}Rb_xTiOMO_4$ ($0 \leq x \leq 1$; M = P or As ) substrate.

47. A short wavelength light source apparatus according to one of claims 45 or 46, wherein the optical wavelength converting element (605) is divided into a plurality of regions having different polarization inversion period from one another.

48. A short wavelength light source apparatus according to claim 47, wherein the wavelength of light incident to the optical wavelength converting element (605) is adjusted to be a phase matching wavelength of the optical wavelength converting element by varying the angle of the optical element, whereby the wavelength of the short wavelength light is varied.

49. A short wavelength light source apparatus according to claim 46, wherein the optical wavelength converting element has a chirp structure having a varying polarization inversion period.

50. A short wavelength light source apparatus according to claim 49, wherein the wavelength of light incident to the optical wavelength converting element is adjusted to be a phase matching wavelength of the optical wavelength converting element by varying the angle of the optical element, whereby the wavelength of the short wavelength light is varied.

51. A short wavelength light source apparatus according to one of claims 45 to 50, wherein the optical element (603) is a thin film optical element including a substrate and a dielectric multilayer film formed on the substrate.

52. A short wavelength light source apparatus according to one of claims 45 to 50, wherein the optical element comprises a dielectric multilayer film formed on an incident end face or an outgoing end face of at least one of the semiconductor laser (601) and the optical wavelength converting element (605).

53. A short wavelength light source apparatus according to one of claims 45 to 50, wherein the optical element (603) is disposed at an angle with the optical axis of the semiconductor laser (801).

54. A short wavelength light source apparatus according to one of claims 45 to 53 further comprising a rotation mechanism for rotating the optical element (603).

55. A short wavelength light source apparatus according to claim 54 further comprising means for varying the phase matching wavelength of the optical wavelength converting element (605), wherein the wavelength of light incident to the optical wavelength converting element is adjusted to be the phase matching wavelength by varying the angle of the optical element (603), whereby the wavelength of the short wavelength light is varied.

56. A short wavelength light source apparatus according to claim 54, wherein the wavelength of light incident to the optical wavelength converting element is adjusted to be a phase matching wavelength of the optical wavelength converting element by varying the angle of the optical element, whereby the wavelength of the short wavelength light is varied.

57. A short wavelength light source apparatus according to claim 54, wherein the rotation mechanism includes a feedback circuit for controlling the output power of the short wavelength light to be constant.

58. A short wavelength light source apparatus according to claim 54, wherein the rotation mechanism includes a piezo element.

59. A short wavelength light source apparatus according to claim 54, wherein the rotation mechanism includes an actuator.

60. A short wavelength light source apparatus according to one of claims 45 to 59 further comprising more than one optical element besides the optical element (603).

61. A short wavelength light source apparatus according to one of claims 45 to 60, wherein the optical element includes a thin film functioning as a $\lambda/2$ plate for the wavelength of the laser light.

62. A short wavelength light source apparatus according to one of claims 45 to 61, wherein the wavelength selection mirror functioning as a transmission type film for the laser light and functioning as a reflective type film for the short wavelength light is provided on the optical element.

63. A short wavelength light source apparatus according to one of claims 45 to 62, wherein a λ/2 plate is located between the semiconductor laser (601) and the converting element (605).

**Patentansprüche**

1. Vorrichtung mit kurzwellenlängiger bzw. Kurzwellen-Lichtquelle mit:

einem Halbleiterlaser (101), welcher eine aktive Schicht zum Emittieren bzw. Aussenden von Laser-Licht aufweist;
einem optischen Element (106) zum Umwandeln (converting) der Wellenlänge, zum Empfangen bzw. Aufnehmen von mindestens einem Teil des Laser-Lichtes, welches von dem Halbleiter-Laser (101) emittiert bzw. ausgesandt wird, und zum Erzeugen eines Lichts mit kurzer Wellenlänge, welches eine Wellenlänge aufweist, welche kürzer ist als die Wellenlänge des Laser-Lichtes; und
einem optischen Element (103), welches zwischen dem Halbleiter-Laser (101) und dem optischen Element (106) zum Umwandeln der Wellenlänge angeordnet ist, zum selektiven bzw. ausgewählten Reflektieren eines Teils des Laser-Lichtes, welches zu einem vorgegebenen bzw. bestimmten Wellenlängenband gehört, und zum Rückkoppeln bzw. Rückführen (feed back) des reflektierten Lichts zur der aktiven Schicht des Halbleiterlasers (101), um so eine stabile Oszillation bzw. Schwingung in einem einzelnen longitudinalen Modus zu erhalten,
**dadurch gekennzeichnet,** dass
das optische Element (103) ein optisches Dünnfilmelement (103) ist, welches dielelektrische Schichten aufweist,
das optische Element (106) zum Umwandeln der Wellenlänge ein Polarisations-Umkehrungs- bzw. -Inversions-Element eines Quasi-Phasenanpassungs-Typs (QPM; quasi-phase-matching) mit einem Wellenleiter ist, und
die Polarisationsrichtung des von dem Halbleiterlaser (101) emittierten bzw. ausgesandten Laserlichtes so festgelegt bzw. eingestellt ist, dass sie mit der Polarisationsrichtung des Wellenleiters des optischen Elements (106) zum Umwandeln der Wellenlänge zusammenfällt bzw. übereinstimmt.

2. Vorrichtung mit Kurzwellen-Lichtquelle nach Anspruch 1, wobei das optische Element (106) zum Umwandeln der Wellenlänge in einem $LiNb_xTa_{1-x}O_3$ $(0 \leq x \leq 1)$ Substrat oder einem $K_{1-x}Rb_xTiOMO_4$ $(0 \leq x \leq 1;\ M = P\ oder\ As\ )$ Substrat ausgebildet ist.

3. Vorrichtung mit Kurzwellen-Lichtquelle nach einem der Ansprüche 1 oder 2, wobei das optische Element (103) ein optisches Dünnfilmelement eines reflektierenden Bragg-Typs ist und dielektrische Schichten aufweist, welche verschiedene Brechungsindizes haben, wobei die dielektrischen Schichten mit einer vorgegebenen Periode bzw. in einem bestimmten Abstand ausgebildet sind.

4. Vorrichtung mit Kurzwellen-Lichtquelle nach einem der Ansprüche 1 oder 2, wobei das optische Element ein optisches Dünnfilmelement (103) ist, welches ein Substrat und einen dielektrischen Mehr- bzw. Vielschicht- (multilayer) Film aufweist, welcher auf dem Substrat ausgebildet ist.

5. Vorrichtung mit Kurzwellen-Lichtquelle nach einem der Ansprüche 1 oder 2, wobei das optische Element (103) einen dielektrischen Mehrschichtfilm (303) aufweist, welcher auf einer Eintritts- bzw. Einfalls-Endoberfläche oder einer Auslass- bzw. Austritts-Endoberfläche von mindestens dem Halbleiterlaser (101) oder dem optischen Element zum Umwandeln der Wellenlänge (106) ausgebildet ist.

6. Vorrichtung mit Kurzwellen-Lichtquelle nach einem der Ansprüche 1 bis 5, weiter aufweisend mehr als ein optisches Element neben dem optischen Dünnfilmelement (103).

7. Vorrichtung mit Kurzwellen-Lichtquelle nach einem der vorhergehenden Ansprüche, wobei das optische Element (103) einen Dünnfilm (304) aufweist, welcher als eine λ/2-Platte bzw. -Schicht für die Wellenlänge des Laserlichtes wirkt.

8. Vorrichtung mit Kurzwellen-Lichtquelle nach einem der vorhergehenden Ansprüche, wobei eine λ/2-Platte (104) zwischen dem Halbleiterlaser (101) und dem Polarisations-Umkehrungs- bzw. -Inversions-Element (106) vom QPM-Typ angeordnet ist.

9. Vorrichtung mit Kurzwellen-Lichtquelle mit:

einem Halbleiterlaser (301), welcher eine aktive Schicht zum Emittieren bzw. Aussenden von Laser-Licht aufweist;
einem optischen Element (306) zum Umwandeln (converting) der Wellenlänge, zum Empfangen von mindestens einem Teil des Laser-Lichtes, welches von dem Halbleiter-Laser (301) emittiert bzw. ausgesandt wird, und zum Erzeugen eines Lichts mit kurzer Wellenlänge, welches eine Wellenlänge aufweist, welche kürzer ist als die Wellenlänge des Laser-Lichtes;

wobei das optische Element (306) zum Umwandeln der Wellenlänge eine Einfallsendoberfläche (307) zum Empfangen bzw. Aufnehmen von mindestens einem Teil des Laserlichtes aufweist, und eine Austrittsendoberfläche, durch welche das Licht mit kurzer Wellenlänge austritt; und

einem optischen Element (303), welches zwischen dem Halbleiterlaser (301) und dem optischen Element (306) zum Umwandeln der Wellenlänge angeordnet ist;

**dadurch gekennzeichnet,** dass

das optische Element (303) ein optisches Dünnfilmelement (303) ist, welches dielektrische Schichten aufweist, zum selektiven bzw. ausgewählten Übertragen bzw. Übermitteln eines Teils des Laserlichtes, welches zu einem vorgegebenen Wellenlängenband gehört, dass das optische Element zum Umwandeln der Wellenlänge ein Polarisations-Umkehrungs- bzw. -Inversions-Element eines Quasi-Phasenanpassungs-Typs (QPM; quasi-phase-matching) mit einem Wellenleiter ist,

der Halbleiterlaser (301) und das optische Element (306) zum Umwandeln der Wellenlänge in einer solchen Art angeordnet sind, dass der Teil des Laserlichtes, welcher durch bzw. über das optische Element (303) übertragen wird, durch die bzw. an der Einfallsendoberfläche (307) des optischen Elements (306) zum Umwandeln der Wellenlänge reflektiert wird, um so zurück durch bzw. über das optische Dünnfilmelement (303) übertragen zu werden und zu der aktiven Schicht des Halbleiterlasers (301) rückgekoppelt bzw. zurückgeführt zu werden, um so eine stabile Schwingung bzw. Oszillation in einem einzelnen longitudinalen Modus zu erhalten bzw. erzielen, und dass die Polarisationsrichtung des Laserlichtes, welches von dem Halbleiterlaser (301) emittiert bzw. ausgesandt wird, so eingestellt bzw. festgelegt ist, dass sie mit der Polarisationsrichtung des Wellenleiters des optischen Elements (306) zum Umwandeln der Wellenlänge zusammenfällt bzw. übereinstimmt.

10. Vorrichtung mit Kurzwellen-Lichtquelle nach Anspruch 9, wobei das optische Element (106) zum Umwandeln der Wellenlänge in einem LiNb$_x$Ta$_{1-x}$O$_3$ $(0 \leq x \leq 1)$ Substrat oder einem K$_{1-x}$Rb$_x$TiOMO$_4$ $(0 \leq x \leq 1;$ M = P oder As ) Substrat ausgebildet ist.

11. Vorrichtung mit Kurzwellen-Lichtquelle nach Anspruch 9, wobei das optische Element zum Umwandeln der Wellenlänge in eine Mehrzahl von Bereichen aufgeteilt bzw. unterteilt ist, welche voneinander verschiedene Polarisations-Umkehr- bzw. -Inversions-Perioden bzw. -Abstände aufweisen.

12. Vorrichtung mit Kurzwellen-Lichtquelle nach Anspruch 11, wobei die Wellenlänge des Lichts, welches auf das optische Element zum Umwandeln der Wellenlänge einfällt, durch Verändern bzw. Einstellen des Winkels des optischen Elements so eingestellt bzw. angepasst ist, dass sie eine phasenangepasste bzw. in der Phase passende (phase matching) Wellenlänge des optischen Elements zum Umwandeln der Wellenlänge ist, wodurch die Wellenlänge des kurzwellenlängigen bzw. Kurzwellenlichtes verändert bzw. eingestellt wird.

13. Vorrichtung mit Kurzwellen-Lichtquelle nach Anspruch 9, wobei das optische Element zum Umwandeln der Wellenlänge eine Chirp-Struktur aufweist mit einer schwankenden bzw. unterschiedlichen Polarisations-Inversions- bzw. - Umkehr-Periode bzw. -Abstand.

14. Vorrichtung mit Kurzwellen-Lichtquelle nach Anspruch 13, wobei die Wellenlänge des Lichtes, welches auf das optische Element zum Umwandeln der Wellenlänge einfällt, so eingestellt bzw. abgeglichen wird, dass es eine phasenangepasste bzw. phasenabgeglichene Wellenlänge des optischen Elements zum Umwandeln der Wellenlänge ist, durch Verändern bzw. Einstellen des Winkels des optischen Elements, wodurch die Wellenlänge des Kurzwellenlichts verändert bzw. eingestellt wird.

15. Vorrichtung mit Kurzwellen-Lichtquelle nach einem der Ansprüche 9 bis 14, wobei das optische Element (503) ein optisches Dünnfilmelement ist und ein Substrat und einen dielektrischen Mehrschichtfilm aufweist, welcher auf dem Substrat ausgebildet ist.

16. Vorrichtung mit Kurzwellen-Lichtquelle nach einem der Ansprüche 9 bis 14, wobei das optische Element einen dielektrischen Mehrschichtfilm aufweist, welcher auf einer Einfallsendoberfläche oder einer Austrittsendoberfläche von dem Halbleiterlaser und/oder dem optischen Element zum Umwandeln der Wellenlänge ausgebildet ist.

17. Vorrichtung mit Kurzwellen-Lichtquelle nach einem der Ansprüche 9 bis 14, wobei das optische Element mit einem Winkel in Bezug auf die optische Achse des Halbleiterlasers angeordnet ist.

18. Vorrichtung mit Kurzwellen-Lichtquelle nach einem der Ansprüche 9 bis 15, weiter aufweisend einen Dreh- bzw. Rotations-Mechanismus zum Drehen des optischen Elements (503).

19. Vorrichtung mit Kurzwellen-Lichtquelle nach Anspruch 18 weiter aufweisend eine Vorrichtung zum Verändern der phasenangepassten bzw. phasenabgeglichenen Wellenlänge des optischen Elements (506) zum Umwandeln der Wellenlänge, wobei eine Wellenlänge des Lichts, welches auf das optische Element (506) zum Umwandeln der Wellenlänge einfällt, so eingestellt bzw. abgeglichen ist, dass sie die phasenangepasste Wellenlänge ist, indem der Winkel des optischen Elements verändert wird, wodurch die Wellenlänge des Kurzwellenlichtes verändert wird.

20. Vorrichtung mit Kurzwellen-Lichtquelle nach Anspruch 18, wobei die Wellenlänge des Lichtes, welches auf das optische Element (506) zum Umwandeln der Wellenlänge einfällt, so eingestellt bzw. abgeglichen ist, dass sie eine phasenangepasste Wellenlänge des optischen Elements (506) zum Umwandeln der Wellenlänge ist, indem der Winkel des optischen Elements (503) verändert wird, wodurch die Wellenlänge des Kurzwellenlichtes verändert wird.

21. Vorrichtung mit Kurzwellen-Lichtquelle nach Anspruch 18, wobei der Drehmechanismus einen Rückkopplungs- bzw. Rückführungsschaltkreis aufweist zum Regeln bzw. Steuern der Ausgangsleistung des Kurzwellenlichtes, so dass diese konstant ist.

22. Vorrichtung mit Kurzwellen-Lichtquelle nach Anspruch 18, wobei der Drehmechanismus ein Piezo-Element aufweist.

23. Vorrichtung mit Kurzwellen-Lichtquelle nach Anspruch 18, wobei der Drehmechanismus einen Aktor bzw. Aktuator bzw. ein Einstellglied aufweist.

24. Vorrichtung mit Kurzwellen-Lichtquelle nach einem der Ansprüche 9 bis 23 weiter aufweisend mehr als ein optisches Element außer bzw. neben dem optischen Element.

25. Vorrichtung mit Kurzwellen-Lichtquelle nach Anspruch 18, wobei der Drehmechanismus einen Dünnfilm aufweist, welcher als eine λ/2-Platte bezüglich der Wellenlänge des Laserlichtes wirkt.

26. Vorrichtung mit Kurzwellen-Lichtquelle nach einem der Ansprüche 9 bis 24, wobei eine λ/2-Platte (304) zwischen dem Halbleiterlaser (301) und dem Element (306) angeordnet ist.

27. Vorrichtung mit Kurzwellen-Lichtquelle mit:

einem Halbleiterlaser (501), welcher eine aktive Schicht zum Emittieren bzw. Aussenden von Laser-Licht aufweist;

einem optischen Element (506) zum Umwandeln (converting) der Wellenlänge zum Empfangen von mindestens einem Teil des Laser-Lichtes, welches von dem Halbleiter-Laser (501) emittiert bzw. ausgesandt wird, und zum Erzeugen eines Lichts mit kurzer Wellenlänge, welches eine Wellenlänge aufweist, welche kürzer ist als die Wellenlänge des Laser-Lichtes;

wobei das optische Element (506) zum Umwandeln der Wellenlänge eine Einfallsendoberfläche (507) aufweist zum Aufnehmen bzw. Empfangen von mindestens einem Teil des Laserlichtes, und eine Austrittsendoberfläche (508), durch welche das Kurzwellenlicht austritt; und

einem optischen Element (503), welches zwischen dem Halbleiterlaser (501) und dem optischen Element (506) zum Umwandeln der Wellenlänge angeordnet ist,

**dadurch gekennzeichnet,** dass

das optische Element (506) zum Umwandeln der Wellenlänge (506) ein Polarisations-Umkehrungs- bzw. -Inversions-Element eines Quasi-Phasenanpassungs-Typs (QPM; quasi-phase-matching) mit einem Wellenleiter ist, und

das optische Element (503) ein optisches Dünnfilmelement ist, welches dielektrische Schichten aufweist zum selektiven bzw. ausgewählten Übertragen eines Teils des Laserlichtes, welches zu einem vorgegebenen Wellenlängenband gehört, wobei der Halbleiterlaser (501) und das optische Element (506) zum Umwandeln der Wellenlänge auf eine solche Art angeordnet sind, dass der Teil des Laserlichts, welcher durch bzw. über das optische Dünnfilmelement (503) übertragen wird, in das optische Element (506) zum Umwandeln der Wellenlänge bei seiner Einfallsendoberfläche (507) eintritt und danach an bzw. von der Austrittsendoberfläche (508) des optischen Elements zum Umwandeln der Wellenlänge (506) so reflektiert wird, dass es zurück durch bzw. über das optische Dünnfilmelement (503) übertragen bzw. übermittelt wird und zu der aktiven Schicht des Halbleiterlasers (501) rückgekoppelt bzw. rückgeführt wird, um eine stabile Oszillation bzw. Schwingung in einem einzelnen longitudinalen Modus zu erhalten, und

die Polarisationsrichtung des Laserlichts, welches von dem Halbleiterlaser (501) emittiert bzw. ausgesandt wird, ist so eingestellt bzw. festgelegt, dass diese mit der Polarisationsrichtung des Wellenleiters des optischen Elements (506) zum Umwandeln der Wellenlänge zusammenfällt.

28. Vorrichtung mit Kurzwellen-Lichtquelle nach Anspruch 27, wobei das optische Element (506) zum Umwandeln der Wellenlänge in einem $LiNb_xTa_{1-x}O_3$ ($0 \leq x \leq 1$) Substrat oder einem $K_{1-x}Rb_xTiOMO_4$ ($0 \leq x \leq 1$; M = P oder As) Substrat ausgebildet ist.

29. Vorrichtung mit Kurzwellen-Lichtquelle nach Anspruch 27, wobei das optische Element (506) zum Umwandeln der Wellenlänge in eine Mehrzahl von Bereichen unterteilt ist, welche voneinander verschiedene Polarisations-Inversions- bzw. -Umkehr-Perioden bzw. -Abstände aufweisen.

30. Vorrichtung mit Kurzwellen-Lichtquelle nach Anspruch 29, wobei die Wellenlänge des Lichtes, welches auf das optische Element (506) zum Umwandeln der Wellenlänge einfällt bzw. auftrifft, so eingestellt bzw. angepasst ist, dass sie eine phasenangepasste Wellenlänge ist, durch Verändern des Winkels des optischen Elements, wodurch die Wellenlänge des Kurzwellenlichtes verändert wird.

31. Vorrichtung mit Kurzwellen-Lichtquelle nach Anspruch 27, wobei das optische Element (506) zum Umwandeln der Wellenlänge eine Chirp-Struktur aufweist mit einer schwankenden bzw. unterschiedlichen Polarisations-Inversions- bzw. -Umkehr-Periode bzw. -Abstand.

32. Vorrichtung mit Kurzwellen-Lichtquelle nach Anspruch 31, wobei die Wellenlänge des Lichtes, welches auf das optische Element zum Umwandeln der Wellenlänge einfällt, so eingestellt bzw. abgeglichen ist, dass sie eine phasenangepasste bzw. phasenabgeglichene Wellenlänge des optischen Elements zum Umwandeln der Wellenlänge ist, durch Verändern bzw. Einstellen des Winkels des optischen Elements, wodurch die Wellenlänge des Kurzwellenlichts verändert bzw. eingestellt wird.

33. Vorrichtung mit Kurzwellen-Lichtquelle nach einem der Ansprüche 27 bis 32, wobei das optische Element ein optisches Dünnfilmelement (503) ist und ein Substrat und einen dielektrischen Mehrschichtfilm aufweist, welcher auf dem Substrat ausgebildet ist.

34. Vorrichtung mit Kurzwellen-Lichtquelle nach einem der Ansprüche 27 bis 32, wobei das optische Element (503) einen dielektrischen Mehrschichtfilm aufweist, welcher auf einer Einfallsendoberfläche oder einer Austrittsendoberfläche von dem Halbleiterlaser (501) und/oder dem optischen Element zum Umwandeln der Wellenlänge (506) ausgebildet ist.

35. Vorrichtung mit Kurzwellen-Lichtquelle nach einem der Ansprüche 27 bis 32, wobei das optische Element (503) mit einem Winkel in Bezug auf die optische Achse des Halbleiterlasers (501) angeordnet ist.

36. Vorrichtung mit Kurzwellen-Lichtquelle nach einem der Ansprüche 27 bis 35, weiter aufweisend einen Dreh- bzw. Rotations-Mechanismus zum Drehen des optischen Elements (503).

37. Vorrichtung mit Kurzwellen-Lichtquelle nach Anspruch 36 weiter aufweisend eine Vorrichtung zum Verändern der phasenangepassten Wellenlänge des optischen Elements zum Umwandeln der Wellenlänge, wobei eine Wellenlänge des Lichts, welches auf das optische Element zum Umwandeln der Wellenlänge einfällt, so eingestellt bzw. abgeglichen wird, dass sie die phasenangepasste Wellenlänge ist, indem der Winkel des optischen Elements verändert wird, wodurch die Wellenlänge des Kurzwellenlichtes verändert wird.

38. Vorrichtung mit Kurzwellen-Lichtquelle nach Anspruch 36, wobei die Wellenlänge des Lichtes, welches auf das optische Element zum Umwandeln der Wellenlänge einfällt, so eingestellt bzw. abgeglichen ist, dass sie eine phasenangepasste Wellenlänge des optischen Elements zum Umwandeln der Wellenlänge ist, indem der Winkel des optischen Elements verändert wird, wodurch die Wellenlänge des Kurzwellenlichtes verändert wird.

39. Vorrichtung mit Kurzwellen-Lichtquelle nach Anspruch 36, wobei der Drehmechanismus einen Rückkopplungs- bzw. Rückführungsschaltkreis aufweist zum Regeln bzw. Steuern der Ausgangsleistung des Kurzwellenlichtes, so dass diese konstant ist.

40. Vorrichtung mit Kurzwellen-Lichtquelle nach Anspruch 36, wobei der Drehmechanismus ein Piezo-Element aufweist.

41. Vorrichtung mit Kurzwellen-Lichtquelle nach Anspruch 36, wobei der Drehmechanismus einen Aktor bzw. Aktuator bzw. ein Einstellglied aufweist.

42. Vorrichtung mit Kurzwellen-Lichtquelle nach einem der Ansprüche 27 bis 41 weiter aufweisend mehr als ein optisches Element außer bzw. neben dem optischen Dünnfilmelement.

43. Vorrichtung mit Kurzwellen-Lichtquelle nach einem der Ansprüche 27 bis 42, wobei das optische Dünnfilmelement (603) einen Dünnfilm (604) aufweist, welcher als eine λ/2-Platte für die bzw. bezüglich der Wellenlänge des Laserlichtes wirkt.

44. Vorrichtung mit Kurzwellen-Lichtquelle nach einem der Ansprüche 27 bis 42, wobei eine λ/2-Platte (504) zwischen dem Halbleiterlaser (501) und dem Element angeordnet ist.

45. Vorrichtung mit Kurzwellen-Lichtquelle mit:

einem Halbleiterlaser (601), welcher eine aktive Schicht zum Emittieren bzw. Aussenden von Laser-Licht aufweist;
einem optischen Element (606) zum Umwandeln (converting) der Wellenlänge zum Empfangen von mindestens einem Teil des Laser-Lichtes, welches von dem Halbleiter-Laser (601) emittiert bzw. ausgesandt wird, und zum Erzeugen eines Lichts mit kurzer Wellenlänge, welches eine Wellenlänge aufweist, welche kürzer ist als die Wellenlänge des Laser-Lichtes;
wobei das optische Element (606) zum Umwandeln der Wellenlänge einen Wellenleiter aufweist und eine Einfallsendoberfläche (680) aufweist zum Empfangen bzw. Aufnehmen von mindestens einem Teil des Laserlichts, und eine Ausgangs- bzw. Austrittsendoberfläche (608), und
einem optischen Element (603), welches zwischen dem Halbleiterlaser (601) und dem optischen Element (605) zum Umwandeln der Wellenlänge angeordnet ist,
**dadurch gekennzeichnet,** dass
das optische Element zum Umwandeln der Wellenlänge ein Polarisations-Umkehrungs- bzw. -Inversions-Element eines Quasi-Phasenanpassungs-Typs (QPM; quasi-phase-matching) ist,
das optische Element ein optisches Dünnfilmelement (603) ist und dielektrische Schichten aufweist zum selektiven bzw. ausgewählten Übertragen eines Teils des Laserlichtes, welches zu dem vorgegebenen bzw. bestimmten Wellenlängenband gehört,
ein Wellenlängenauswahlspiegel (607) vorgesehen ist zum selektiven Übertragen eines Teils des Laserlichts, welches zu einem vorgegebenen Wellenlängenband gehört, und zum Reflektieren des Kurzwellenlängenlichts, wobei der Wellenlängenauswahlspiegel (607) zwischen dem Halbleiterlaser (601) und dem optischen Element (606) zum Umwandeln der Wellenlänge angeordnet ist, und
ein Teil des Laserlichts, welcher zu dem vorgegebenen Wellenlängenband gehört, wird durch bzw. über das optische Dünnfilmelement (603) und den Wellenlängenauswahlspiegel (607) übertragen bzw. übermittelt, von der Einfallsendoberfläche (680) des optischen Elements (606) zum Umwandeln der Wellenlänge reflektiert, und danach zurück übertragen durch bzw. über das optische Dünnfilmelement (603) und den Wellenlängenauswahlspiegel (607), um so zu der aktiven Schicht des Halbleiterlasers (601) zurückgeführt bzw. rückgekoppelt zu werden, um eine stabile Oszillation bzw. Schwingung in einem einzelnen longitudinalen Modus zu erhalten,
das Kurzwellenlängenlicht, welches von dem optischen Element (606) zum Umwandeln der Wellenlänge erzeugt wird, wird von bzw. an der Austrittsendoberfläche (680) des optischen Elements (606) zum Umwandeln der Wellenlänge reflektiert, zurück durch den Wellenleiter übertragen bzw. breitet sich durch diesen aus, und wird danach in einer vorgegebenen Richtung durch den Wellenlängenauswahlspiegel (607) reflektiert, und
die Polarisationsrichtung des Laserlichtes, welches von dem Halbleiterlaser (601) emittiert bzw. ausgesandt ist, wird so eingestellt bzw. festgelegt, dass sie mit der Polarisationsrichtung eines Wellenleiters des optischen Elements (605) zum Umwandeln der Wellenlänge übereinstimmt bzw. zusammenfällt.

46. Vorrichtung mit Kurzwellen-Lichtquelle nach Anspruch 45, wobei das optische Element (605) zum Umwandeln der Wellenlänge in einem $LiNb_xTa_{1-x}O_3$ ($0 \leq x \leq 1$) Substrat oder einem $K_{1-x}Rb_xTiOMO_4$ ($0 \leq x \leq 1$; M = P oder As ) Substrat ausgebildet ist.

47. Vorrichtung mit Kurzwellen-Lichtquelle nach einem der Ansprüche 45 oder 46, wobei das optische Element (605) zum Umwandeln der Wellenlänge in eine Mehrzahl von Bereichen unterteilt ist, welche voneinander verschiedene Polarisations-Inversions- bzw. -Umkehr-Perioden bzw. -Abstände aufweisen

48. Vorrichtung mit Kurzwellen-Lichtquelle nach Anspruch 47, wobei die Wellenlänge des Lichtes, welches auf das optische Element (605) zum Umwandeln der Wellenlänge einfällt, so eingestellt bzw. abgeglichen ist, dass sie eine phasenangepasste Wellenlänge des optischen Elements zum Umwandeln der Wellenlänge ist, durch Verändern bzw. Einstellen des Winkels des optischen Elements, wodurch die Wellenlänge des Kurzwellenlängenlichts verändert wird.

49. Vorrichtung mit Kurzwellen-Lichtquelle nach Anspruch 46, wobei das optische Element zum Umwandeln der Wellenlänge eine Chirp-Struktur aufweist mit einer schwankenden bzw. unterschiedlichen Polarisations-Inversions- bzw. -Umkehr-Periode bzw. -Abstand.

50. Vorrichtung mit Kurzwellen-Lichtquelle nach Anspruch 49, wobei die Wellenlänge des Lichtes, welches auf das optische Element zum Umwandeln der Wellenlänge einfällt, so eingestellt bzw. abgeglichen ist, dass sie eine phasenangepasste bzw. phasenabgeglichene Wellenlänge des optischen Elements zum Umwandeln der Wellenlänge ist, durch Verändern bzw. Einstellen des Winkels des optischen Elements, wodurch die Wellenlänge des Kurzwellenlichts verändert bzw. eingestellt wird.

51. Vorrichtung mit Kurzwellen-Lichtquelle nach einem der Ansprüche 45 bis 50, wobei das optische Element (603) ein optisches Dünnfilmelement ist und ein Substrat und einen dielektrischen Mehrschichtfilm aufweist, welcher auf dem Substrat ausgebildet ist.

52. Vorrichtung mit Kurzwellen-Lichtquelle nach einem der Ansprüche 45 bis 50, wobei das optische Element einen dielektrischen Mehrschichtfilm aufweist, welcher auf einer Einfallsendoberfläche oder einer Austrittsendoberfläche von dem Halbleiterlaser (601) und/oder dem optischen Element zum Umwandeln der Wellenlänge (605) ausgebildet ist.

53. Vorrichtung mit Kurzwellen-Lichtquelle nach einem der Ansprüche 45 bis 50, wobei das optische Element (603) mit bzw. unter einem Winkel in Bezug auf die optische Achse des Halbleiterlasers (601) angeordnet ist.

54. Vorrichtung mit Kurzwellen-Lichtquelle nach einem der Ansprüche 45 bis 53, weiter aufweisend einen Dreh- bzw. Rotations-Mechanismus zum Drehen des optischen Elements (603).

55. Vorrichtung mit Kurzwellen-Lichtquelle nach Anspruch 54, weiter aufweisend eine Vorrichtung zum Verändern der phasenangepassten Wellenlänge des optischen Elements (605) zum Umwandeln der Wellenlänge, wobei die Wellenlänge des Lichts, welches auf das optische Element zum Umwandeln der Wellenlänge einfällt, so eingestellt bzw. abgeglichen ist, dass es die phasenangepasste Wellenlänge ist, indem der Winkel des optischen Elements (603) verändert wird, wodurch die Wellenlänge des Kurzwellenlichtes verändert wird.

56. Vorrichtung mit Kurzwellen-Lichtquelle nach Anspruch 54, wobei die Wellenlänge des Lichtes, welches auf das optische Element zum Umwandeln der Wellenlänge einfallt, so eingestellt bzw. abgeglichen ist, dass es eine phasenangepasste Wellenlänge des optischen Elements zum Umwandeln der Wellenlänge ist, indem der Winkel des optischen Elements verändert wird, wodurch die Wellenlänge des Kurzwellenlichtes verändert wird.

57. Vorrichtung mit Kurzwellen-Lichtquelle nach Anspruch 54, wobei der Drehmechanismus einen Rückkopplungs- bzw. Rückführungsschaltkreis aufweist zum Regeln bzw. Steuern der Ausgangsleistung des Kurzwellenlichtes, so dass diese konstant ist.

58. Vorrichtung mit Kurzwellen-Lichtquelle nach Anspruch 54, wobei der Drehmechanismus ein Piezo-Element aufweist.

59. Vorrichtung mit Kurzwellen-Lichtquelle nach Anspruch 54, wobei der Drehmechanismus einen Aktor bzw. Aktuator bzw. ein Einstellglied aufweist.

60. Vorrichtung mit Kurzwellen-Lichtquelle nach einem der Ansprüche 45 bis 59, weiter aufweisend mehr als ein optisches Element außer bzw. neben dem optischen Element (603).

61. Vorrichtung mit Kurzwellen-Lichtquelle nach einem der Ansprüche 45 bis 60, wobei das optische Element einen Dünnfilm aufweist, welcher als eine $\lambda/2$-Platte für die Wellenlänge des Laserlichtes wirkt.

62. Vorrichtung mit Kurzwellen-Lichtquelle nach einem der Ansprüche 45 bis 61, wobei der Spiegel zum Auswählen bzw. zur Selektion der Wellenlänge, welcher als ein Film des Durchgangs- bzw . Transmissions-Typs bezüglich des Laserlichts wirkt und als ein Film eines reflektierenden Typs bezüglich des Kurzwellenlängenlichts wirkt, auf dem optischen Element vorgesehen ist.

63. Vorrichtung mit Kurzwellen-Lichtquelle nach einem der Ansprüche 45 bis 62, wobei eine $\lambda/2$-Platte zwischen dem Halbleiterlaser (601) und dem Umwandlungselement (605) angeordnet ist.

## Revendications

1. Appareil à source de lumière à courte longueur d'onde comprenant :

   - un laser à semi-conducteur (101) incluant une couche active pour émettre la lumière laser ;
   - un élément de conversion de longueur d'onde optique (106) pour recevoir au moins une partie de la lumière laser émise depuis le laser à semi-conducteur (101) et pour générer une lumière à courte longueur d'onde ayant une longueur d'onde plus courte que la longueur d'onde de la lumière laser ; et

- un élément optique (103) disposé entre le laser à semi-conducteur (101) et l'élément de conversion de longueur d'onde optique (106) pour réfléchir sélectivement une partie de la lumière laser qui appartient à une bande de longueur d'onde prédéterminée et pour renvoyer la lumière réfléchie vers la couche active du laser à semi-conducteur (101) de façon à obtenir une oscillation stable dans un monomode longitudinal,
  caractérisé en ce que
- l'élément optique (103) est un élément optique à film mince (103) comprenant des couche diélectriques,
- l'élément de conversion de longueur d'onde optique (106) est un élément à inversion de polarisation du type à adaptation quasi-phase (QPM) comportant un guide d'onde, et
- la direction de polarisation de la lumière laser émise depuis le laser à semi-conducteur (101) est établie pour coïncider avec la direction de polarisation dudit guide d'onde de l'élément de conversion de longueur d'onde optique (106).

2. Appareil à source de lumière à courte longueur d'onde selon la revendication 1, dans lequel l'élément de conversion de longueur d'onde optique (106) est formé dans un substrat constitué de $LinB_xTa_{1-x}O_3$ ($0 \leq X \leq 1$) ou un substrat constitué de $K_{1-x}Rb_xTiOMO_4$ ($0 \leq X \leq 1$; M = P ou As).

3. Appareil à source de lumière à courte longueur d'onde selon l'une des revendications 1 ou 2, dans lequel l'élément optique (103) est un élément optique à film mince du type à réflexion de Bragg comprenant des couches diélectriques présentant différents indices de réfraction, les couches diélectriques étant formées selon une période prédéterminée.

4. Appareil à source de lumière à courte longueur d'onde selon l'une des revendications 1 ou 2, dans lequel l'élément optique est un élément optique à film mince (103) incluant un substrat et un film multicouche diélectrique formé sur le substrat.

5. Appareil à source de lumière à courte longueur d'onde selon l'une des revendications 1 ou 2, dans lequel l'élément optique (103) comprend un film multicouche diélectrique (303) formé sur une face d'extrémité incidente ou sur une face d'extrémité de sortie d'au moins un élément parmi le laser à semi-conducteur (101) et l'élément de conversion de longueur d'onde optique (106).

6. Appareil à source de lumière à courte longueur d'onde selon l'une des revendications 1 à 5, comprenant, en outre, plus d'un élément optique en dehors de l'élément optique à film mince (103).

7. Appareil à source de lumière à courte longueur d'onde selon l'une quelconque des revendications précédentes, dans lequel l'élément optique (103) inclut un film mince (304) fonctionnant comme une lame $\lambda/2$ pour la longueur d'onde de la lumière laser.

8. Appareil à source de lumière à courte longueur d'onde selon l'une quelconque des revendications précédentes, dans lequel une lame $\lambda/2$ (104) est placée entre le laser à semi-conducteur (101) et l'élément à inversion de polarisation du type à adaptation quasi-phase (106).

9. Appareil à source de lumière à courte longueur d'onde comprenant :

- un laser à semi-conducteur (301) incluant une couche active pour émettre la lumière laser ;
- un élément de conversion de longueur d'onde optique (306) pour recevoir au moins une partie de la lumière laser émise depuis le laser à semi-conducteur (301) et pour générer une lumière à courte longueur d'onde ayant une longueur d'onde plus courte que la longueur d'onde de la lumière laser,
- dans lequel l'élément de conversion de longueur d'onde optique (306) comporte une face d'extrémité incidente (307) pour recevoir au moins une partie de la lumière laser et une face d'extrémité de sortie à travers laquelle la lumière à courte longueur d'onde sort ; et
- un élément optique (303) disposé entre le laser à semi-conducteur (301) et l'élément de conversion de longueur d'onde optique (306) ;
  caractérisé en ce que
- l'élément optique (303) est un élément optique à film mince (303) comprenant des couches diélectriques pour transmettre sélectivement une partie de la lumière laser qui appartient à une bande de longueur d'onde prédéterminée ; et en ce que
- l'élément de conversion de longueur d'onde optique est un élément d'inversion de polarisation du type à adaptation quasi-phase (QPM) comportant un guide d'onde ;
- le laser à semi-conducteur (301) et l'élément de conversion de longueur d'onde optique (306) sont disposés d'une manière telle que la partie de la lumière laser transmise à travers l'élément optique (303) est réfléchie par la face d'extrémité incidente (307) de l'élément de conversion de longueur d'onde optique (306) de façon à être retransmise à travers l'élément optique à film mince (303) et renvoyée vers la couche active du laser à semi-conducteur (301) de manière à obtenir une oscillation stable dans un monomode longitudinal, et en ce que

- la direction de polarisation de la lumière laser émise depuis le laser à semi-conducteur (301) est établie pour coïncider avec la direction de polarisation dudit guide d'onde de l'élément de conversion de longueur d'onde optique (306).

10. Appareil à source de lumière à courte longueur d'onde selon la revendication 9, dans lequel l'élément de conversion de longueur d'onde optique est formé dans un substrat de $LinB_xTa_{1-x}O_3$ ($0 \leq X \leq 1$) ou un substrat de $K_{1-x}Rb_xTiOMO_4$ ($0 \leq X \leq 1$; M = P ou As ).

11. Appareil à source de lumière à courte longueur d'onde selon la revendication 9, dans lequel l'élément de conversion de longueur d'onde optique est divisé en une pluralité de régions ayant différentes périodes d'inversion de polarisation les unes par rapport aux autres.

12. Appareil à source de lumière à courte longueur d'onde selon la revendication 11, dans lequel la longueur d'onde de la lumière incidente sur l'élément de conversion de longueur d'onde optique est ajustée pour être une longueur d'onde d'adaptation de phase de l'élément de conversion de longueur d'onde optique en faisant varier l'angle de l'élément optique, d'où il résulte que la longueur d'onde de la lumière à courte longueur d'onde est variée.

13. Appareil à source de lumière à courte longueur d'onde selon la revendication 9, dans lequel l'élément de conversion de longueur d'onde optique possède une structure dispersée ayant une période d'inversion de polarisation variable.

14. Appareil à source de lumière à courte longueur d'onde selon la revendication 13, dans lequel la longueur d'onde de la lumière incidente sur l'élément de conversion de longueur d'onde optique est ajustée pour être la longueur d'onde d'adaptation de phase de l'élément de conversion de longueur d'onde optique en faisant varier l'angle de l'élément optique, d'où il résulte que la longueur d'onde de la lumière à courte longueur d'onde est variée.

15. Appareil à source de lumière à courte longueur d'onde selon l'une des revendications 9 à 14, dans lequel l'élément optique (503) est un élément optique à film mince incluant un substrat et un film multicouche diélectrique formé sur le substrat.

16. Appareil à source de lumière à courte longueur d'onde selon l'une des revendications 9 et 14, dans lequel l'élément optique comprend un film multicouche diélectrique formé sur une face d'extrémité incidente ou sur une face d'extrémité de sortie d'au moins un élément parmi le laser à semi-conducteur et l'élément de conversion de longueur d'onde optique.

17. Appareil à source de lumière à courte longueur d'onde selon l'une des revendications 9 à 14, dans lequel l'élément optique est disposé selon un certain angle par rapport à un axe optique du laser à semi-conducteur.

18. Appareil à source de lumière à courte longueur d'onde selon l'une des revendications 9 à 15 comprenant, en outre, un mécanisme de rotation pour faire tourner l'élément optique (503).

19. Appareil à source de lumière à courte longueur d'onde selon la revendication 18 comprenant, en outre, un moyen pour faire varier la longueur d'onde d'adaptation de phase de l'élément de conversion de longueur d'onde optique (506), dans lequel une longueur d'onde de la lumière incidente sur l'élément de conversion de longueur d'onde optique (506) est ajustée pour être la longueur d'onde d'adaptation de phase en faisant varier l'angle de l'élément optique, d'où il résulte que la longueur d'onde de la lumière à courte longueur d'onde est variée.

20. Appareil à source de lumière à courte longueur d'onde selon la revendication 18, dans lequel la longueur d'onde de la lumière incidente sur l'élément de conversion de longueur d'onde optique (506) est ajustée pour être une longueur d'onde d'adaptation de phase de l'élément de conversion de longueur d'onde optique (506) en faisant varier l'angle de l'élément optique (503), d'où il résulte que la longueur d'onde de la lumière à courte longueur d'onde est variée.

21. Appareil à source de lumière à courte longueur d'onde selon la revendication 18, dans lequel le mécanisme de rotation inclut un circuit d'asservissement pour commander la puissance de sortie de la lumière à courte longueur d'onde afin qu'elle soit constante.

22. Appareil à source de lumière à courte longueur d'onde selon la revendication 18, dans lequel le mécanisme de rotation inclut un élément piézo-électrique.

23. Appareil à source de lumière à courte longueur d'onde selon la revendication 18, dans lequel le mécanisme de rotation inclut un organe de commande.

**24.** Appareil à source de lumière à courte longueur d'onde selon l'une des revendications 9 à 23 comprenant, en outre, plus d'un élément optique en dehors de l'élément optique.

**25.** Appareil à source de lumière à courte longueur d'onde selon la revendication 18, dans lequel le mécanisme de rotation inclut un film mince fonctionnant comme une lame $\lambda/2$ pour la longueur d'onde de la lumière laser.

**26.** Appareil à source de lumière à courte longueur d'onde selon les revendications 9 à 24, dans lequel une lame $\lambda/2$ (304) est placée entre le laser à semi-conducteur (301) et l'élément (306).

**27.** Appareil à source de lumière à courte longueur d'onde comprenant :

- un laser à semi-conducteur (501) incluant une couche active pour émettre la lumière laser ;
- un élément de conversion de longueur d'onde optique (506) pour recevoir au moins une partie de la lumière laser émise depuis le laser à semi-conducteur (501) et pour générer une lumière à courte longueur d'onde ayant une longueur d'onde plus courte que la longueur d'onde de la lumière laser,
  dans lequel l'élément de conversion de longueur d'onde optique (506) comporte une face d'extrémité incidente (507) pour recevoir au moins une partie de la lumière laser et une face d'extrémité de sortie à travers laquelle la lumière à courte longueur d'onde sort ; et
- un élément optique (503) disposé entre le laser à semi-conducteur (501) et l'élément de conversion de longueur d'onde optique (506) ; caractérisé en ce que
- l'élément de conversion de longueur d'onde optique (506) est un élément d'inversion de polarisation du type à adaptation quasi-phase (QPM) comportant un guide d'onde ;
- l'élément optique (503) est un élément optique à film mince comprenant des couches diélectriques pour transmettre sélectivement une partie de la lumière laser qui appartient à une bande de longueur d'onde prédéterminée, le laser à semi-conducteur (501) et l'élément de conversion de longueur d'onde optique (506) sont disposés d'une manière telle que la partie de la lumière laser transmise à travers l'élément optique à film mince (503) entre dans l'élément de conversion de longueur d'onde optique (506) au niveau de sa face d'extrémité incidente (507) et est par la suite réfléchie par la face d'extrémité de sortie (508) de l'élément de conversion de longueur d'onde optique (506) de façon à être retransmise à travers l'élément optique à film mince (503) et renvoyée vers la couche active du laser à semi-conducteur (501) de manière à obtenir une oscillation stable dans un monomode longitudinal, et en ce que

- la direction de polarisation de la lumière laser émise depuis le laser à semi-conducteur (501) est établie pour coïncider avec la direction de polarisation dudit guide d'onde de l'élément de conversion de longueur d'onde optique (506).

**28.** Appareil à source de lumière à courte longueur d'onde selon la revendication 27, dans lequel l'élément de conversion de longueur d'onde optique (506) est formé dans un substrat de $LinB_xTa_{1-x}O_3$ ($0 \leq X \leq 1$) ou un substrat de $K_{1-x}Rb_xTiOMO_4$ ($0 \leq X \leq 1$; M = P ou As ).

**29.** Appareil à source de lumière à courte longueur d'onde selon la revendication 27, dans lequel l'élément de conversion de longueur d'onde optique (506) est divisé en une pluralité de régions ayant différentes périodes d'inversion de polarisation les unes par rapport aux autres.

**30.** Appareil à source de lumière à courte longueur d'onde selon la revendication 29, dans lequel la longueur d'onde de la lumière incidente sur l'élément de conversion de longueur d'onde optique (506) est ajustée pour être une longueur d'onde d'adaptation de phase en faisant varier l'angle de l'élément optique, d'où il résulte que la longueur d'onde de la lumière à courte longueur d'onde est variée.

**31.** Appareil à source de lumière à courte longueur d'onde selon la revendication 27, dans lequel l'élément de conversion de longueur d'onde optique (506) possède une structure dispersée ayant une période d'inversion de polarisation variable.

**32.** Appareil à source de lumière à courte longueur d'onde selon la revendication 31, dans lequel la longueur d'onde de la lumière incidente sur l'élément de conversion de longueur d'onde optique est ajustée pour être la longueur d'onde d'adaptation de phase de l'élément de conversion de longueur d'onde optique en faisant varier l'angle de l'élément optique, d'où il résulte que la longueur d'onde de la lumière à courte longueur d'onde est variée.

**33.** Appareil à source de lumière à courte longueur d'onde selon l'une des revendications 27 à 32, dans lequel l'élément optique (503) est un élément optique à film mince incluant un substrat et un film multicouche diélectrique formé sur le substrat.

**34.** Appareil à source de lumière à courte longueur d'onde selon l'une des revendications 27 à 32, dans lequel l'élément optique comprend un film multicouche diélectrique formé sur une face d'extrémité incidente ou sur une face d'extrémité de sortie d'au moins un élément parmi le laser à semi-conducteur '501) et l'élément de conversion de longueur d'onde optique (506).

35. Appareil à source de lumière à courte longueur d'onde selon l'une des revendications 27 à 32, dans lequel l'élément optique (503) est disposé selon un certain angle par rapport à un axe optique du laser à semi-conducteur.

36. Appareil à source de lumière à courte longueur d'onde selon l'une des revendications 27 à 35 comprenant, en outre, un mécanisme de rotation pour faire tourner l'élément optique (503).

37. Appareil à source de lumière à courte longueur d'onde selon la revendication 36 comprenant, en outre, un moyen pour faire varier une longueur d'onde d'adaptation de phase de l'élément de conversion de longueur d'onde optique, dans lequel la longueur d'onde de la lumière incidente sur l'élément de conversion de longueur d'onde optique est ajustée pour être la longueur d'onde d'adaptation de phase en faisant varier l'angle de l'élément optique, d'où il résulte que la longueur d'onde de la lumière à courte longueur d'onde est variée.

38. Appareil à source de lumière à courte longueur d'onde selon la revendication 36, dans lequel la longueur d'onde de la lumière incidente sur l'élément de conversion de longueur d'onde optique est ajustée pour être une longueur d'onde d'adaptation de phase de l'élément de conversion de longueur d'onde optique en faisant varier l'angle de l'élément optique, d'où il résulte que la longueur d'onde de la lumière à courte longueur d'onde est variée.

39. Appareil à source de lumière à courte longueur d'onde selon la revendication 36, dans lequel le mécanisme de rotation inclut un circuit d'asservissement pour commander la puissance de sortie de la lumière à courte longueur d'onde afin qu'elle soit constante.

40. Appareil à source de lumière à courte longueur d'onde selon la revendication 36, dans lequel le mécanisme de rotation inclut un élément piézo-électrique.

41. Appareil à source de lumière à courte longueur d'onde selon la revendication 36, dans lequel le mécanisme de rotation inclut un organe de commande.

42. Appareil à source de lumière à courte longueur d'onde selon l'une des revendications 27 à 41 comprenant, en outre, plus d'un élément optique en dehors de l'élément optique.

43. Appareil à source de lumière à courte longueur d'onde selon l'une des revendications 27 à 42, dans lequel l'élément optique à film mince (603) inclut un film mince fonctionnant comme une lame λ/2 pour la longueur d'onde de la lumière laser.

44. Appareil à source de lumière à courte longueur d'onde selon les revendications 9 à 24, dans lequel une lame λ/2 (304) est placée entre le laser à semi-conducteur (301) et l'élément (306).

45. Appareil à source de lumière à courte longueur d'onde comprenant :

- un laser à semi-conducteur (601) incluant une couche active pour émettre la lumière laser ;
- un élément de conversion de longueur d'onde optique (606) pour recevoir au moins une partie de la lumière laser émise depuis le laser à semi-conducteur (601) et pour générer une lumière à courte longueur d'onde ayant une longueur d'onde plus courte que la longueur d'onde de la lumière laser,
  dans lequel l'élément de conversion de longueur d'onde optique (606) inclut un guide d'onde et comporte une face d'extrémité incidente (608) pour recevoir au moins une partie de la lumière laser et ne comporte pas d'extrémité de sortie (608),
  et
- un élément optique (603) disposé entre le laser à semi-conducteur (601) et l'élément de conversion de longueur d'onde optique (606),
  caractérisé en ce que
- l'élément de conversion de longueur d'onde optique est un élément d'inversion de polarisation du type à adaptation quasi-phase (QPM),
- l'élément optique est un élément optique à film mince (603) comprenant des couches diélectriques pour transmettre sélectivement une partie de la lumière laser qui appartient à une bande de longueur d'onde prédéterminée,
- un miroir de sélection de longueur d'onde (607) est prévu pour transmettre sélectivement une partie de la lumière laser qui appartient à une bande de longueur d'onde prédéterminée et pour réfléchir la lumière à courte longueur d'onde, le miroir de sélection de longueur d'onde (607) étant disposé entre le laser à semi-conducteur (601) et l'élément de conversion de longueur d'onde optique (606), et
  une partie de la lumière laser qui appartient à la bande de longueur d'onde prédéterminée est transmise à travers l'élément optique à film mince (603) et le miroir de sélection de longueur d'onde (607), réfléchie par la face d'extrémité incidente (80) de l'élément de conversion de longueur d'onde optique (606) et est retransmise par la suite à travers l'élément optique à film mince (603) et le miroir de sélection de longueur d'onde (607) de façon à être renvoyée vers la couche active du laser à semi-conducteur (601) afin d'obtenir une oscillation stable dans un monomode longitudinal, la lumière à courte longueur d'onde générer par l'élément de conversion de longueur d'onde optique (606) est réfléchie par la face d'extrémité de sortie (80) de l'élément de conversion de longueur d'onde optique (606), repropagée à travers le guide d'onde et est ensuite réfléchie dans une direction prédéterminée par le miroir de sélection de longueur d'onde (607), et la direction de polarisation de la lumière laser émise depuis le laser à semi-conducteur (601) est établie pour coïncider avec la direction de polarisation d'un guide d'onde de l'élément de conversion de longueur d'onde optique (605).

46. Appareil à source de lumière à courte longueur d'onde selon la revendication 45, dans lequel l'élément de conversion de longueur d'onde optique (605) est formé dans un substrat de LINb$_x$TA$_{1-x}$O$_3$ ($0 \leq X \leq 1$) ou un substrat de K$_{1-x}$Rb$_x$TiOMO$_4$ ($0 \leq X \leq 1$; M = P ou As ).

47. Appareil à source de lumière à courte longueur d'onde selon l'une des revendications 45 ou 46, dans lequel l'élément de conversion de longueur d'onde optique (605) est divisé en une pluralité de régions ayant différentes périodes d'inversion de polarisation les unes par rapport aux autres.

48. Appareil à source de lumière à courte longueur d'onde selon la revendication 47, dans lequel la longueur d'onde de la lumière incidente sur l'élément de conversion de longueur d'onde optique (605) est ajustée pour être une longueur d'onde d'adaptation de phase de l'élément de conversion de longueur d'onde optique en faisant varier l'angle de l'élément optique, d'où il résulte que la longueur d'onde de la lumière à courte longueur d'onde est variée.

49. Appareil à source de lumière à courte longueur d'onde selon la revendication 46, dans lequel l'élément de conversion de longueur d'onde optique (506) possède une structure dispersée ayant une période d'inversion de polarisation variable.

50. Appareil à source de lumière à courte longueur d'onde selon la revendication 49, dans lequel la longueur d'onde de la lumière incidente sur l'élément de conversion de longueur d'onde optique est ajustée pour être la longueur d'onde d'adaptation de phase de l'élément de conversion de longueur d'onde optique en faisant varier l'angle de l'élément optique, d'où il résulte que la longueur d'onde de la lumière à courte longueur d'onde est variée.

51. Appareil à source de lumière à courte longueur d'onde selon l'une des revendications 45 à 50, dans lequel l'élément optique (603) est un élément optique à film mince incluant un substrat et un film multicouche diélectrique formé sur le substrat.

52. Appareil à source de lumière à courte longueur d'onde selon l'une des revendications 45 à 50, dans lequel l'élément optique comprend un film multicouche diélectrique formé sur une face d'extrémité incidente ou sur une face d'extrémité de sortie d'au moins un élément parmi le laser à semi-conducteur (601) et l'élément de conversion de longueur d'onde optique (606).

53. Appareil à source de lumière à courte longueur d'onde selon l'une des revendications 45 à 50, dans lequel l'élément optique (603) est disposé selon un certain angle par rapport à un axe optique du laser à semi-conducteur (601).

54. Appareil à source de lumière à courte longueur d'onde selon l'une des revendications 45 à 53 comprenant, en outre, un mécanisme de rotation pour faire tourner l'élément optique (603).

55. Appareil à source de lumière à courte longueur d'onde selon la revendication 54 comprenant, en outre, un moyen pour faire varier la longueur d'onde d'adaptation de phase de l'élément de conversion de longueur d'onde optique (605), dans lequel la longueur d'onde de la lumière incidente sur l'élément de conversion de longueur d'onde optique est ajustée pour être la longueur d'onde d'adaptation de phase en faisant varier l'angle de l'élément optique (603), d'où il résulte que la longueur d'onde de la lumière à courte longueur d'onde est variée.

56. Appareil à source de lumière à courte longueur d'onde selon la revendication 54, dans lequel la longueur d'onde de la lumière incidente sur l'élément de conversion de longueur d'onde optique est ajustée pour être une longueur d'onde d'adaptation de phase de l'élément de conversion de longueur d'onde optique en faisant varier l'angle de l'élément optique, d'où il résulte que la longueur d'onde de la lumière à courte longueur d'onde est variée

57. Appareil à source de lumière à courte longueur d'onde selon la revendication 54, dans lequel le mécanisme de rotation inclut un circuit d'asservissement pour commander la puissance de sortie de la lumière à courte longueur d'onde afin qu'elle soit constante.

**58.** Appareil à source de lumière à courte longueur d'onde selon la revendication 54, dans lequel le mécanisme de rotation inclut un élément piézo-électrique.

**59.** Appareil à source de lumière à courte longueur d'onde selon la revendication 54, dans lequel le mécanisme de rotation inclut un organe de commande.

**60.** Appareil à source de lumière à courte longueur d'onde selon l'une des revendications 45 à 59 comprenant, en outre, plus d'un élément optique en dehors de l'élément optique.

**61.** Appareil à source de lumière à courte longueur d'onde selon l'une des revendications 45 à 60, dans lequel l'élément optique à film mince (603) inclut un film mince fonctionnant comme une lame $\lambda/2$ pour la longueur d'onde de la lumière laser.

**62.** Appareil à source de lumière à courte longueur d'onde selon l'une des revendications 45 à 61, dans lequel le miroir de sélection de longueur d'onde fonctionnant comme un film de type à transmission pour la lumière laser et fonctionnant comme un film du type à réflexion pour la lumière à courte longueur d'onde est prévu sur l'élément optique.

**63.** Appareil à source de lumière à courte longueur d'onde selon l'une des revendications 45 à 62, dans lequel une lame $\lambda/2$ est placé entre le laser à semi-conducteur (601) et l'élément de conversion (605).

*FIG.1*

# FIG. 2

## FIG.3

Fundamental wave

Harmonic wave

870nmAF

435nmAF

FIG.4

FIG.5

504 503 505
502
501
Fundamental    Fundamental
wave    506    wave    Harmonic
wave

507    508
870nmAR
870nmHF
435nmAF

FIG.6

602 604 603    607    605
601
Fundamental wave
and
606    Harmonic wave

680    609
870nmAR    870nmHR
435nmAR    435nmHR

Harmonic
wave

*FIG.7*

701
702
Fundamental wave
705
Harmonic wave

703
704

706
870nmAR

707
870nmHR
435nmAR

*FIG.8*

801
802
803
806
804
805

Harmonic wave

807
870nmAR
435nmAR

808
870nmHR
435nmHR

41

*FIG.9A*

*FIG.9B*

## FIG.10 A

Optical polarization direction

8°  A03  3.6°

A04

10 μm

A01  A02

## FIG.10 B

A07  A06

Polarization direction

Harmonic wave

Curvature 10 mm

A05

*FIG.11A*

*FIG.11B*

*FIG.11C*

EP 0 625 811 B1

*FIG.12*

FIG.13

## FIG.14

FIG. 15

Optical
polarization
direction